# EUROPÄISCHE PATENTSCHRIFT

(11) **EP 3 863 059 B1**
(45) Veröffentlichungstag und Bekanntmachung des Hinweises auf die Patenterteilung: **31.07.2024**
(21) Anmeldenummer: 20155403.7
(22) Anmeldetag: 04.02.2020
(51) Int. Cl.: H10K 39/36, H10K 85/50, G01T 1/24

(54) **PEROWSKIT-BASIERTE DETEKTOREN MIT ERHÖHTER ADHÄSION**
PEROVSKITE DETECTORS WITH ENHANCED ADHESION
DÉTECTEURS À BASE DE PEROWSKIT À ADHÉRENCE ÉLEVÉE

(43) Veröffentlichungstag der Anmeldung: 11.08.2021
(73) Patentinhaber: Siemens Healthineers AG, 91301 Forchheim (DE)
(72) Erfinder: DEUMEL, Sarah, 91054 Erlangen-Sieglitzhof (DE); TEDDE, Sandro Francesco, 91085 Weisendorf (DE); HÜRDLER, Judith Elisabeth, 90419 Nürnberg (DE)
(74) Vertreter: Siemens Healthineers Patent Attorneys

(56) Entgegenhaltungen:
- EP-A1- 3 376 260
- WO-A2-2018/009712

## Beschreibung

Die vorliegende Erfindung betrifft einen Detektor für elektromagnetische Strahlung, umfassend eine erste, pixelierte Elektrodenschicht, eine zweite Elektrode, und eine erste Schicht umfassend mindestens einen ersten Perowskit, welche sich zwischen der ersten, pixelierten Elektrodenschicht und der zweiten Elektrode befindet, sowie ein Verfahren zur Herstellung eines entsprechenden Detektors.

Digitale Röntgendetektoren finden eine Vielzahl von Anwendungsmöglichkeiten, beispielsweise in der medizinischen Diagnostik, wo sie üblicherweise in Größen zwischen 20x20 cm² und 43x43 cm² bereitgestellt werden. Derzeitige Detektoren basieren auf amorphem Silizium (indirekte Konversion) und amorphem Selen (direkte Konversion).

Bei der direkten Konversion regen Röntgenquanten einen Partikel an, was in der Bildung eines Elektron-Loch-Paares resultiert. Diese können nach Anwendung eines elektrischen Feldes zu Elektroden wandern, wo sie detektiert werden. Die direkte Konversion von Röntgenstrahlen in Selen wird üblicherweise mit bis zu 1 mm dicken, vorgeladenen Schichten in einer blockierenden Richtung im kV-Bereich durchgeführt. Eine direkte Konversion erzielt dabei normalerweise im Gegensatz zur Detektion mit indirekten Wandlern, welche leichter und billiger hergestellt werden können, eine verbesserte Auflösung.

Bei der indirekten Konversion regen Röntgenquanten ein Szintillationsmaterial (z.B. CsI:Tl, mit Thallium dotiertes Cäsiumiodid; oder mit Terbium dotiertes Gadoliniumoxysulfid), an, welches in der Bildung von sichtbaren Photonen resultiert. Diese können dann zu beispielsweise einem gestapelten Photodetektor-Array, welcher z.B. aus amorphen Silizium (a-Si) Photodioden hergestellt ist, die für die Konversion von Photon zu Ladung sorgen. Nach Anlegen eines elektrischen Feldes können diese Ladungen an Photodetektor-Elektroden detektiert werden.

Eine Alternative zu den zwei genannten Röntgenstrahlen-Detektortechnologien, welche auf anorganischen Halbleitern basieren, stellen hybrid-organische Detektoren dar, welche üblicherweise aus der flüssigen Phase oder aus Pulvern hergestellt werden. Diese ermöglichen eine einfache Herstellung mit Größen von 43x43 cm² und mehr. Üblicherweise werden anorganische Absorbermaterialien wie Quantendots oder Szintillatorpartikel wie Gadoliniumoxysulfid in die organische Matrix eingebracht. Organische Halbleiter können einfach auf großen Oberflächen aus der flüssigen Phase oder aus Pulvern appliziert werden, und optischer Cross-Talk kann durch direktes Einbringen des anorganischen Szintillatormaterials minimiert werden. Derzeit gibt es noch keine hybriden Röntgendetektoren auf dem Markt. Aufgrund von isotroper Lichtemission in Szintillatoren weisen indirekte Wandler üblicherweise eine schlechte Auflösung im Vergleich zu direkten Wandlern auf.

Zur Verbesserung der Adhäsion und Gewährleistung der elektrischen Kontaktierung (Pixel per Pixel) in einem Mehrschichtsystem für Detektoren gibt es bereits mehrere Ansätze.

Insbesondere direkt wandelnde Röntgendetektoren werden üblicherweise entweder durch Aufwachsen des Aktivmaterials direkt auf der Backplane, z.B. a-Se durch PECVD (plasmaunterstützte chemische Gasphasenabscheidung) oder durch Bump Bonding des Aktivmaterials auf der Backplane, z.B. CdTe oder CZT (Cadmium Zink Tellurid) hergestellt. Beide Verfahren weisen keine Adhäsionsprobleme auf, sind jedoch teuer und zeitaufwändig. Übliche Startmaterialiensind darüber hinaus teuer und im Falle eines kristallinen Materials beschränkt auf die maximale Wafergröße, wenn kein Butting verwendet wird.

Standardisierte Verbindunsgtechniken wie das Bump Bonding, welche in der Halbleiterbranche angewendet werden, sind üblicherweise aufgrund der kleinen Pixelflächen (von teilweise unter 50 pm) und der riesigen Anzahl der Pixel (bis 4000x4000 Pixel) nicht einfach auf andere Detektoranwendungen wie beispielsweise in Röntgendetektoren übertragbar. Ebenso können anisotrop leitende und adhäsive Materialen wie z.B. leitfähige Kleber oder Folien ACF (Anisotropic Conductive Film), die mit leitenden Partikeln (z.B. Silberpartikeln) versetzt sind, aufgrund von Kurzschlüssen einzelner Pixel, teilweise nicht "angeschlossenen" Pixeln (tote Pixel) und nicht ausreichender Kontaktfläche im Pixel nicht verwendetwerden.

Als neue Detektormaterialien werden in letzter Zeit halbleitende Perowskite genannt. Halbleitende Perowskite sind ein kostengünstiges Material für Photovoltaik (PV), Laser, LED und Röntgendetektion, wie z.B. in H. Wei et al., "Sensitive X-ray detectors made of methylammonium lead tribromide perovskite single crystals", Nature Photonics 10, 2016, pp. 333-339, doi:10.1038/nphoton.2016.41 ; S. Shrestha et al., "Highperformance direct conversion X-ray detectors based on sintered hybrid lead triiodide perovskite wafers", Nature Photonics 11, 2017, pp. 436-440, doi:10.1038/nphoton.2017.94 ; und S. Yakunin et al., "Detection of X-ray photons by solution-processed lead halide perovskites", Nature Photonics 9, 2015, pp. 444-449 doi:10.1038/nphoton.2015.82 beschrieben. Auch für diese Materialien ergibt sich jedoch eine Haftungsproblematik.

Zur Lösung hierfür ist beispielsweise die Auftragung einer relativ dünnen Haftschicht in EP 3474339 A1 genannt. Wie in der EP 3474339 A1 beschrieben, können Haftschichten aufgetragen werden, die durch ihre chemischen und mechanischen Eigenschaften die Adhäsion verbessern können. Ein bereits oft publiziertes Material hierfür ist Pedot:Sorbitol. Jedoch ist dieser Ansatz für dünne Schichten mit wenigen µm Dicken oder weniger entwickelt worden und stößt bei höheren Schichten (>10pm)üblicherweise an seine Grenzen.

Für eine verbesserte Sensitivität sollten jedoch dicke Röntgendetektionsschichten von mehr als 100 µm bereitgestellt werden. Durch Applikation aus der Flüssigphase oder Gasphasenabscheidung werden jedoch große Mengen an Lösungsmittel freigesetzt, und die Oberflächenrauigkeit kann schwer kontrolliert werden. Eine komplette Entgasung von Lösungsmitteln ist nicht nur technisch anspruchsvoll, aber auch hinsichtlich gesundheitlicher und umwelttechnischer Aspekte problematisch.

In der WO 2016/091600 A1 und WO 2016/091442 A1 wird die Herstellung dicker Detektionsschichten umfassend Perowskite unter Verwendung eines Softsinter-Verfahrens vorgeschlagen.

Die Anbindung von dicken Perowskit-Schichten (> 100 pm) auf verschiedenen Substraten (z.B. Glas, polymere Folien, Metallfolien) oder funktionellen Substraten (z.B. a-Si oder Indium-Gallium-Zinkoxid (IGZO) Backplanes für Dünnschichttransistor-(TFT) Array auf Glas oder flexiblen Substraten) ist jedoch aufgrund der schlechten Haftung von z.B. polykristallinen Perowskit-Schichten auf den Substraten selbst schwierig.

Ein weiterer Ansatz ist die mechanische Verankerung von zwei Schichten bzw. Bauteilen. Die EP 2973688 B1 behandelt beispielsweise Sensorbaugruppen, die ein Formkopplungsmerkmal (Ausbuchtung) auf einer Baugruppe und das passende Gegenstück (hervorstehendes Element) auf einer anderen Baugruppe enthält. Das Formkopplungsmerkmal besteht hier speziell aus Ausbuchtungen mit mindestens zwei parallelen Wänden. Durch das Schlüssel-Schloss-Prinzip ist die Sensorbaugruppe in zwei Raumrichtungen gegen Verrutschen gesichert. Auf einem ähnlichen Prinzip beruht die Methode, die in der US 10453763 B2 beschrieben wird. Hierbei handelt es sich um eine Verkapselungsstruktur eines elektronischen Geräts, welche ebenfalls Strukturen wie z.B. Wände besitzt. Ein Hilfsmaterial wird in diese vorgegeben Struktur aufgetragen und erhöht so die Adhäsion der Verkapslungsstruktur zum Substrat des elektronischen Geräts; eine flächige elektronische Kontaktierung einzelner Pixel wird hier nicht in Betracht gezogen.

Ein anderes Verfahren, um die Adhäsion einzelner Bestandteile eines elektronischen Systems zu erhöhen ist das Sintern einer Haftschicht: Die DE 102009040627 stellt ein Verfahren vor, bei dem eine strukturierbare Maskenschicht auf einen Halbleiter-Chip aufgebracht wird. In die durch Photoabtragung oder Ätzen hergestellten Öffnungen wird eine Masse mit elektrisch leitfähigen Partikeln gefüllt, auf der anschließend eine Trägerschicht gelegt wird. Durch Sintern wird die Masse verdichtet, und so erhöht sich die Adhäsion zu der Trägerschicht und den Chip.

Ein möglicher Lösungsansatz ist auch die Auftragung strukturierter Pixel-Elektroden mittels physikalischer Gasphasenabscheidung (PVD, Physical Vapor Deposition) oder chemischer Gasphasenabscheidung (CVD, Chemical Vapor Deposition) mit anschließendem Strukturierungsverfahren Z.B. Photolithographie, Laserabtragung, etc.) direkt auf die Absorberschicht. Hierbei können Standard Lösungen für anisotrope leitfähige Folien (ACF, Anisotropic Conductive Films) verwendet werden. Dieser Ansatz ist jedoch für Absorberschichten aus Perowskit nicht geeignet aufgrund der chemischen Unverträglichkeit zu Entwickler und Lösemittel und der extrem langen Zeit der Laserstrukturierung (auch aufgrund der hohen Anzahl an Pixeln).

Die WO 2018/009712 A2 betrifft Perowskit-Einkristall-Röntgenstrahlendetektoren mit einer für Röntgenwellenlängen sensitiven Schicht beinhaltend einen Organo-Blei-Trihalid-Perowskit-Einkristall, einer Substratschicht umfassend ein Oxid, und einer Bindeschicht zwischen der sensitiven Shcicht und der Substratschicht.

In der EP 3 376 260 A1 ist ein Strahlungsdetektor mit einem Substrat beinhaltend eine Strahlung sammelnde Elektrode, einer Strahlung absorbierenden Schicht beinhaltend Perowskit-Strukturpartikeln und einem Bindeharz, und einer Spannung bereitstellenden Elektrode offenbart.

Es besteht daher weiter eine unzureichende Haftung zwischen einer Perowskit-Absorberschicht, beispielsweise in Röntgen und/oder Gamma-Detektorenund der Ausleseelektronik eines entsprechenden Detektors, insbesondere bei Schichten mit einer Dicke im Bereich von 1 µm - 3000 µm). Hierbei ist insbesondere zu beachten, dass im Falle eines Schichtauftrags eine entsprechende Haftung vermittelnde Schicht leitend oder halbleitend sein sollte, aber die Pixel einer pixelierten Detektorelektrode miteinander nicht kurzschließen sollte, sondern nur die Pixel an die Detektionsschicht "anschließen" sollte.

Die Erfinder haben gefunden, dass eine gute Haftung zwischen einer Schicht umfassend mindestens einen ersten Perowskit und einer ersten, pixelierten Elektrode erzielt werden kann, wenn eine Struktur eingebracht wird, welche die Haftung zwischen beiden erhöht. Insbesondere haben die Erfinder gefunden, dass Haftungsprobleme zwischen einer pixelierten Elektrodenschicht und einer Detektionsschicht umfassend mindestens einen Perowskit (auch als Absorberschicht bezeichnet) in Detektoren für elektromagnetische Strahlung, insbesondere in pixelierten Röntgen- und/oder Gammastrahlendetektoren/Gammadetektoren, vermieden werden können, indem eine Schicht umfassend mindestens einen ersten Perowksit mit einer Struktur, welche als Ankerstruktur dient, mit der pixelierten Elektrodenschicht verbunden wird. Hierzu kann insbesondere mittels Verflüssigung und Rekristallisation von Perowskiten in Kombination eine gute Haftung des mindestens einen ersten Perowskiten bzw. der diesen enthaltenen Schicht eine gute Haftung zur Struktur und somit auch zur pixelierten Elektrodenschicht bzw. sogar zu einem pixelierten Substrat erzielt werden.

In einem ersten Aspekt betrifft die Erfindung einen Detektor für elektromagnetische Strahlung, insbesondere einen Röntgen- und/oder Gammadetektor, umfassend:
- eine erste, pixelierte Elektrodenschicht umfassend eine Vielzahl von Elektrodenpixeln sowie Zwischenräume zwischen den einzelnen Elektrodenpixeln,
- eine zweite Elektrode, und
- eine erste Schicht umfassend mindestens einen ersten Perowskit, welche sich zwischen der ersten, pixelierten Elektrodenschicht und der zweiten Elektrode befindet, weiter umfassend eine Struktur, welche sich zumindest teilweise zwischen der ersten, pixelierten Elektrodenschicht und der zweiten Elektrode befindet und zumindest teilweise zwischen einzelnen Elektrodenpixeln der ersten, pixelierten Elektrodenschicht derart angeordnet ist, dass sie zumindest teilweise auf den Zwischenräumen zwischen den einzelnen Elektrodenpixeln in Richtung der zweiten Elektrode von der ersten Elektrodenschicht weg angeordnet ist, wobei die Schicht umfassend mindestens einen ersten Perowskit zumindest teilweise in der Struktur eingebracht ist.

Weiter offenbart ist ein Verfahren zur Herstellung eines Detektors für elektromagnetische Strahlung, insbesondere eines Röntgen- und/oder Gammadetektors, umfassend:
- Bereitstellen einer ersten, pixelierten Elektrodenschicht umfassend eine Vielzahl von Elektrodenpixeln sowie Zwischenräume zwischen den einzelnen Elektrodenpixeln;
- Aufbringen einer Struktur zumindest teilweise auf die Zwischenräume der ersten, pixelierten Elektrodenschicht, wobei die Struktur derart aufgebracht wird, dass die Struktur zumindest teilweise auf den Zwischenräumen zwischen den einzelnen Elektrodenpixeln von der ersten Elektrodenschicht weg angeordnet ist;
- Einbringen einer ersten Schicht umfassend mindestens einen ersten Perowskit in die Struktur; und
- Aufbringen einer zweiten Elektrode auf die Struktur und/oder die erste Schicht umfassend mindestens einen ersten Perowskit; oder
- Bereitstellen einer Struktur, wobei die Struktur Zwischenräume aufweist;
- Einbringen einer Vielzahl von Elektrodenpixel zwischen die Zwischenräume der Struktur, wobei die Elektrodenpixel die Struktur nicht füllen, und dadurch bilden einer ersten, pixelierten Elektrodenschicht;
- Einbringen einer ersten Schicht umfassend mindestens einen ersten Perowskit in die Struktur; und
- Aufbringen einer zweiten Elektrode auf die Struktur und/oder die erste Schicht umfassend mindestens einen ersten Perowskit.

Weitere Aspekte der vorliegenden Erfindung sind den abhängigen Ansprüchen und der detaillierten Beschreibung zu entnehmen.

Die beiliegenden Zeichnungen sollen Ausführungsformen der vorliegenden Erfindung veranschaulichen und ein weiteres Verständnis dieser vermitteln. Im Zusammenhang mit der Beschreibung dienen sie der Erklärung von Konzepten und Prinzipien der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander dargestellt. Gleiche, funktionsgleiche und gleich wirkende Elemente, Merkmale und Komponenten sind in den Figuren der Zeichnungen, sofern nichts anderes ausgeführt ist, jeweils mit denselben Bezugszeichen versehen.
Figur 1 zeigt schematisch einen beispielhaften erfindungsgemäßen Röntgendetektor.
Figuren 2 bis 11 zeigen schematisch verschiedene beispielhafte Strukturen, welche in erfindungsgemäßen Detektoren Anwendung finden können.

In Figuren 12 bis 14 ist beispielhaft schematisch ein Verfahren dargestellt, wie eine erste Schicht aufgebracht werden kann.

Figuren 15 bis 18 zeigen schematisch beispielhafte erste Schichten in erfindungsgemäßen Detektoren.

In Figuren 19 bis 22 ist schematisch beispielhaft dargestellt, wie eine zweite Schicht auf die erste Schicht aufgebracht werden kann.

Den Figuren 23 bis 25 ist schematisch beispielhaft zu entnehmen, wie eine zweite Schicht aufgebracht werden kann.

Figuren 26 bis 28 zeigen schematisch ein weiteres erfindungsgemäßes Verfahren, bei dem eine erste und zweite Schicht aufgebracht werden.

In Figur 29 sind XRD-Daten eines Perowskits vor und nach einem Rekristallisieren gezeigt.

So nicht anderweitig definiert, haben hierin verwendete technische und wissenschaftliche Ausdrücke dieselbe Bedeutung, wie sie von einem Fachmann auf dem Fachgebiet der Erfindung gemeinhin verstanden wird.

Mengenangaben im Rahmen der vorliegenden Erfindung beziehen sich auf Gew.%, soweit nicht anderweitig angegeben oder aus dem Kontext ersichtlich ist.

Ein erster Aspekt der vorliegenden Erfindung betrifft einen Detektor für elektromagnetische Strahlung, insbesondere einen Röntgen- und/oder Gammadetektor, umfassend:
- eine erste, pixelierte Elektrodenschicht umfassend eine Vielzahl von Elektrodenpixeln sowie Zwischenräume zwischen den einzelnen Elektrodenpixeln,
- eine zweite Elektrode, und
- eine erste Schicht umfassend mindestens einen ersten Perowskit, welche sich zwischen der ersten, pixelierten Elektrodenschicht und der zweiten Elektrode befindet,
weiter umfassend eine Struktur, welche sich zumindest teilweise zwischen der ersten, pixelierten Elektrodenschicht und der zweiten Elektrode befindet und zumindest teilweise zwischen einzelnen Elektrodenpixeln der ersten, pixelierten Elektrodenschicht derart angeordnet ist, dass sie zumindest teilweise auf den Zwischenräumen zwischen den einzelnen Elektrodenpixeln in Richtung der zweiten Elektrode von der ersten Elektrodenschicht weg angeordnet ist, wobei die Schicht umfassend mindestens einen ersten Perowskit zumindest teilweise in der Struktur eingebracht ist.

Dass die erste Schicht umfassend mindestens einen ersten Perowskit in die Struktur eingebracht ist, bedeutet hier insbesondere, dass die erste Schicht in einem Bereich eingebracht ist, der sich zwischen der Struktur oberhalb der Elektrodenpixel erstreckt. Obgleich bei einer zumindest teilweise porösen Struktur mit porösem Material, die hier theoretisch möglich wäre, ein Einbringen der Schicht auch innerhalb des Strukturmaterials möglich ist (was hier nicht ausgeschlossen ist), ist insbesondere mit dem Einbringen gemeint, dass die erste Schicht umfassend den mindestens einen ersten Peroswkit in Bereiche eingebracht wird, welche durch die Struktur definiert sind und zwischen Teilen der Struktur wie etwa Wänden, in einem Gitter, etc. liegen.

Im erfindungsgemäßen Detektor ist die erste, pixelierte Elektrodenschicht nicht besonders beschränkt. Die erste, pixelierte Elektrodenschicht weist hierbei eine Vielzahl (also 2 oder mehr, beispielsweise 3, 4, 5, 6, 7, 8, 9, 10, 100, 1000 oder mehr) von Elektrodenpixeln bzw. Pixeln auf, welche elektrisch kontaktiert werden können. Es ist weder die Pixelgröße noch das Material der Elektrodenpixel besonders beschränkt, und es können Elektrodenpixel verwendet werden, welche bereits bisher in Detektoren für elektromagnetische Strahlung, insbesondere Röntgen- und/oder Gammadetektoren, Anwendung gefunden haben. Als Elektrodenpixel kann beispielsweise ein Elektrodenpixel mit einem Pitch von 98 µm eines quadratischen Elektrodenpixels verwendet werden, was einen Elektrodenpixel definiert, wobei auch andere Pixelgrößen möglich sind. Das Material der Elektrodenpixel ist nicht besonders beschränkt und kann beispielsweise ein leitfähiges Metalloxid, ein leitfähiges Polymer, und/oder ein Metall umfassen, welches zur Detektion eines Elektrons und/oder Lochs, das durch einen Perowskit erzeugt wird, dient. So ein Substrat vorhanden ist, kann ein Substrat ein pixeliertes Substrat sein, auf dem sich die Elektrodenpixel der ersten, pixelierten Elektrodenschicht befinden.

Die erste, pixelierte Elektrodenschicht umfasst eine Vielzahl von Elektrodenpixeln sowie Zwischenräume zwischen den Elektrodenpixeln bzw. Pixeln, welche eine Gitterstruktur bilden können. Die Zwischenräume können bzw. die Gitterstruktur kann hierbei ein nicht leitfähiges Material umfassen, welches nicht besonders beschränkt ist und auch beispielsweise ein Material eines Substrats sein kann, beispielsweise wenn Elektrodenpixel nach Materialentfernung in einem Substrats (z.B. durch Ätzen, etc.) und Einbringen der Elektrodenpixel in ein Substrat eingebracht werden, und/oder auch die Elektrodenpixel der ersten Elektrodenschicht anderweitig gegeneinander isolieren, beispielsweise durch ein Gas wie Luft, etc., beispielsweise wenn die Elektrodenpixel auf ein Substrat aufgebracht werden.

Im erfindungsgemäßen Detektor kann die erste, pixelierte Elektrodenschicht (wie auch die zweite Elektrode und/oder die erste Schicht sowie ggf. weitere Schichten und/oder das Substrat, etc.) eben und/oder gewölbt sein, sodass sich ebene oder auch gewölbte Detektoren ergeben können.

Darüber hinaus ist auch die zweite Elektrode nicht besonders beschränkt. Gemäß bestimmten Ausführungsformen umfasst die zweite Elektrode ein leitfähiges Metalloxid, ein leitfähiges Polymer, und/oder ein Metall. Im erfindungsgemäßen Detektor können die erste und zweite Elektrode (bzw. die erste Elektrodenschicht und die zweite Elektrode) geeignet als Anode und/oder Kathode geschalten sein. Gemäß bestimmten Ausführungsformen ist die zweite Elektrode flächig ausgebildet. Gemäß bestimmten Ausführungsformen ist die zweite Elektrode zumindest teilweise durchlässig oder vollständig durchlässig für eine zu detektierende elektromagnetische Strahlung, welche nicht besonders beschränkt ist und beispielsweise Röntgen- (Wellenlänge ≥ 10 pm und < 10 nm) und/oder Gammastrahlung (Wellenlänge < 10 pm) sein kann. Beispielsweise kann die zweite Elektrode Indiumzinnoxid (ITO), Aluminium-Zink-Oxid (aluminium doped zinc oxide, AZO), Antimon-Zinn-Oxid (antimony tin oxide, ATO) und/oder Fluor-Zinn-Oxid (FTO) umfassen oder daraus bestehen.

Die Struktur ist ebenfalls nicht besonders beschränkt, sofern sie zumindest teilweise oder vollständig zwischen einzelnen Pixeln der ersten, pixelierten Elektrodenschicht angeordnet ist. Hierzu kann sich die Struktur auch teilweise auf Elektrodenpixeln der ersten, pixelierten Elektrodenschicht befinden, sofern sie zumindest teilweise zwischen zwei Elektrodenpixeln der ersten, pixelierten Elektrodenschicht liegt, also beispielweise derart, dass sie in Zwischenräumen bzw. in einer Gitterstruktur der ersten, pixelierten Elektrodenschicht (gebildet beispielsweise aus einem Nichtelektrodenmaterial der ersten, pixelierten Elektrodenschicht und/oder einem Gas wie Luft), direkt auf Zwischenräumen bzw. der Gitterstruktur bzw. dem Material der Zwischenräume bzw. Gitterstruktur zwischen Elektrodenpixeln, und/oder über Zwischenräumen, also ebenfalls auf dem Material der Zwischenräume zwischen Elektrodenpixeln, beispielsweise der Gitterstruktur bzw. dessen Material, angeordnet ist. Hierzu ist die Struktur derart angeordnet, dass sie sich zumindest von der ersten, pixelierten Elektrodenschicht weg hin in Richtung der zweiten Elektrode erstreckt, also eine dreidimensionale Struktur bildet, welche sich zumindest zwischen der ersten, pixelierten Elektrodenschicht und der zweiten Elektrode befindet. Es ist hierbei nicht ausgeschlossen, dass sich auch Teile der Struktur innerhalb der ersten, pixelierten Elektrodenschicht befinden, beispielsweise in den Zwischenräumen, um für eine bessere Verankerung der Struktur zu sorgen. Die Struktur bildet eine Ankerstruktur für zumindest Teile der ersten Schicht, wodurch die erste Schicht besser mit der ersten, pixelierten Elektrodenschicht verbunden werden kann. Durch die Struktur, welche insbesondere als elektrisch isolierende Struktur aufgebracht ist, wird eine Vergrößerung der Ankeroberfläche für die erste Schicht auf der ersten, pixelierten Elektrodenschicht und ggf. somit auch auf einem Substrat ermöglicht.

Die Struktur befindet sich also gemäß bestimmten Ausführungsformen zumindest teilweise oder auch vollständig in einem Bereich, der durch die Zwischenräume bzw. die Gitterstruktur der ersten, pixelierten Elektrodenschicht zwischen einzelnen Elektrodenpixeln definiert ist, wobei die Struktur auch in den Zwischenräumen bzw. der Gitterstruktur liegen kann. Hierbei ist nicht ausgeschlossen, dass die Struktur auch teilweise auf und/oder über den Elektrodenpixeln der ersten, pixelierten Elektrodenschicht liegt. Die Struktur befindet sich derart zwischen den Elektrodenpixeln dass zumindest über den Zwischenräumen der ersten, pixelierten Elektrodenschicht in Richtung der zweiten Elektrode eine 3D-Form gebildet bzw. ein dreidimensionaler Körper gebildet wird. Die Form eines solchen Körpers der Struktur ist nicht besonders beschränkt.

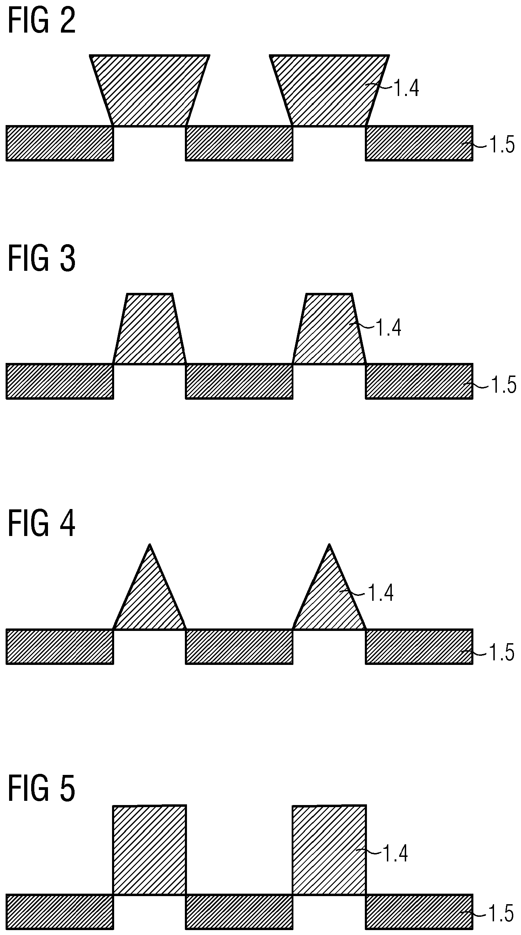

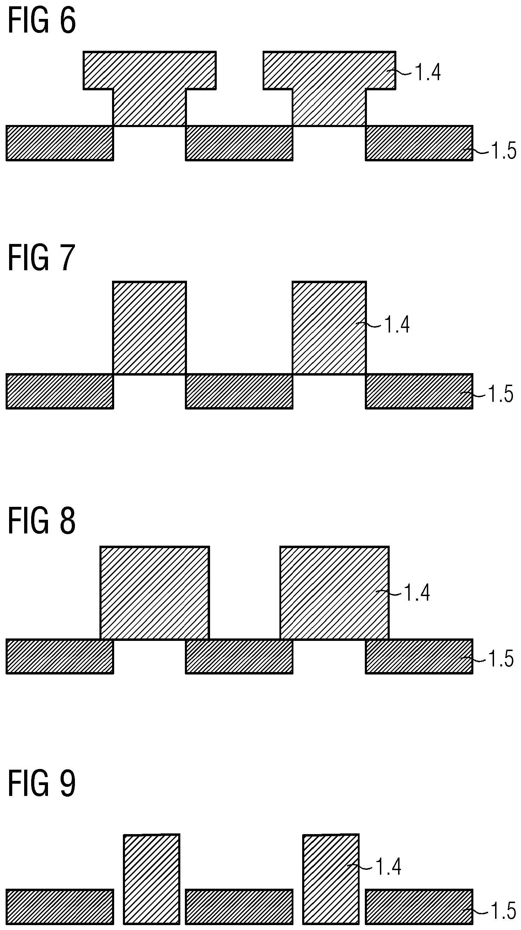

Beispielhafte Formen für die Struktur sind schematisch in Form zweidimensionaler Schnitte in Figuren 2 bis 11 gezeigt. Aus diesen Figuren wird auch deutlich, wie die Struktur 1.4 zumindest teilweise zwischen den Elektrodenpixeln 1.5 angeordnet ist. In Figuren 2 und 3 sind beispielsweise Strukturen gezeigt, welche sich zur (nicht gezeigten, darüber befindlichen) zweiten Elektrode verbreitern bzw. verjüngen. Solche Formen sind beispielsweise durch die Verwendung unterschiedlicher Photolacke (negative bzw. positive Photolacke) bei der Herstellung erhältlich. Auch die in Figuren 4 bis 6 gezeigten Formen sind beispielsweise durch Verwendung verschiedener Photolacke erhältlich, und/oder durch andere, nachfolgend dargelegte Verfahren. Die in Figur 6 gezeigte Form kann z.B. mittels eines Lift-off Resists (LOR) hergestellt werden.

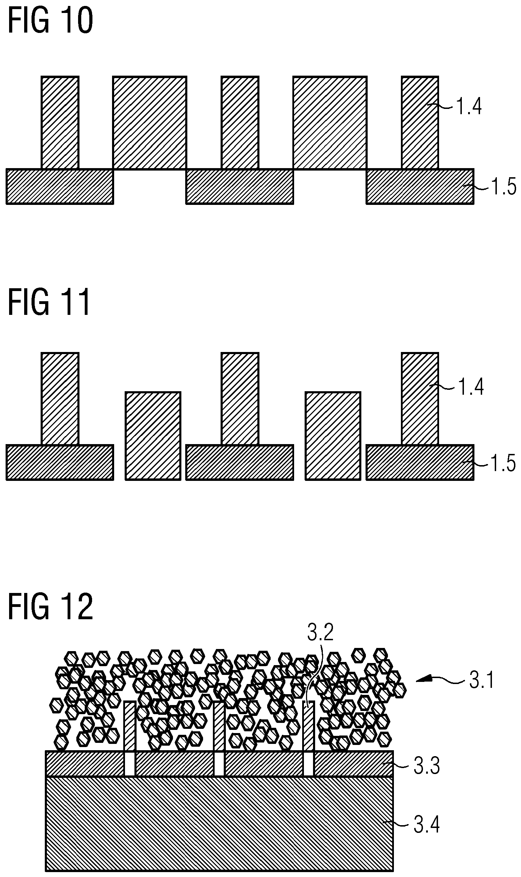

Neben verschiedenen Formen können auch die Abmessungen der Struktur 1.4 variieren, wie in Figuren 7 bis 9 zu sehen ist: Ein Beispiel wäre, dass die Strukturen 1.4 genau zwischen die Elektrodenpixel 1.5 passen (Figur 7); in einem anderen Beispiel ist die Struktur 1.4 breiter als der Abstand zwischen den Elektrodenpixeln 1.5, also der Zwischenraum (Figur 8); alternativ kann die Struktur 1.4 auch schmaler als der Abstand der Elektrodenpixel 1.5 sein, wobei hier dann auch die Struktur 1.4 in die Zwischenräume eingebracht sein kann (was auch in den anderen Figuren nicht ausgeschlossen ist; Figur 9). Weiterhin können auch Teile der Struktur 1.4 noch zusätzlich oberhalb der aktiven Fläche der Elektrodenpixel 1.5 ergänzt werden, wie in den Figuren 10 und 11 schematisch gezeigt wird. Hierdurch kann die Haftung der ersten Schicht weiter verstärkt werden, jedoch kann die Detektion durch die Verringerung der zur Detektion verfügbaren aktiven Fläche der Elektrodenpixel 1.5 ebenfalls verringert sein.

Die verschiedenen Formen der Struktur sind daneben auch auf andere Weise erhältlich, beispielsweise durch selektives Ätzen und/oder Laserabtragung eines Substrats mit anschließender Einbringung der Elektrodenpixel in geätzte und/oder abgetragene Bereiche des Substrats, wobei hierbei dann das Material der Zwischenräume der ersten, pixelierten Elektrodenschicht und der Struktur dem Material des Substrats entsprechen kann, und/oder durch 3D-Drucken. In solchen Fällen sind als Material der Struktur beispielsweise verschiedene Polymere, Keramiken, etc. möglich. Entsprechende Verfahren zum selektiven Ätzen sind beispielsweise aus J.D. Zahn et al., "A direct plasma etch approach to high aspect ratio polymer micromachining with applications in biomems and CMOS-mems", Technical Digest. MEMS 2002 IEEE International Conference. Fifteenth IEEE International Conference on Micro Electro Mechanical Systems, DOI: 10.1109/MEMSYS.2002.984223 bekannt. Ein beispielhaftes Verfahren zum Laserabtragen ist beispielsweise in V.N. Tokarev et al., "High-aspect-ratio microdrilling of polymers with UV laser ablation: experiment with analytical model", Appl. Phys. A, 2002, DOI: 10.1007/s00339-002-1511-8 beschrieben. Ein Verfahren zum 3D-Drucken ist beispielsweise aus A. Kain et al., "High aspect ratio- and 3D-printing of freestanding sophisticated structures", Procedie Chemistry 1, 2009, 750-753, DOI: 10.1016/j.proche.2009.07.187 bekannt.

Auch die Maße der Struktur sind nicht besonders beschränkt. Bevorzugt ist jedoch eine Struktur, welche von der Oberfläche der ersten, pixelierten Elektrodenschicht eine Höhe von 0,5 bis 1500 µm, bevorzugt 1 bis 1000 µm, weiter bevorzugt 2 bis 500 µm, weiter bevorzugt 3 bis 300 µm, noch weiter bevorzugt 5 bis 100 µm, noch weiter bevorzugt 7 bis 70 µm, insbesondere 10 bis 50 µm aufweist. Auch ist eine Struktur mit einen hohen Aspektverhältnis (Verhältnis Höhe zu Breite) bevorzugt, insbesondere wenn sich die Struktur als "Gitter" und/oder "Wand" von der Oberfläche der ersten, pixelierten Elektrodenschicht weg erstreckt, wobei hier dann eine Breite der Wand und/oder der Querstreben des Gitters beispielsweise 0,5 bis 80 µm, bevorzugt 1 bis 50 µm, weiter bevorzugt 2 bis 35 µm, noch weiter bevorzugt 3 bis 25 µm, noch weiter bevorzugt 4 bis 15 µm, insbesondere 5 bis 10 µm, betragen kann, wobei die Breite beispielsweise direkt auf der Oberfläche der ersten, pixelierten Elektrodenschicht gemessen werden kann, insbesondere bei sich verjüngenden oder verbreiternden Strukturen oder anderweitig unregelmäßig geformten Strukturen. Es ist auch nicht ausgeschlossen, dass die Elektrodenpixel in die Struktur bei der Herstellung eingefüllt werden, also erst nach der Struktur erzeugt werden. Hier können ggf. auch höhere Aspektverhältnisse erzielt werden. So die Struktur auch in den Zwischenräumen liegt, befinden sich die Elektrodenpixel quasi in der Struktur, sodass hier die erste, pixelierte Elektrodenschicht auch von Teilen der Struktur gebildet sein kann, im Bereich der Zwischenräume der ersten, pixelierten Elektrodenschicht (hier wäre dann die erste, pixelierte Elektrodenschicht als eine Schicht gleicher Höhe zur Höhe der Elektrodenpixel zu verstehen, die gedanklich aus dem Detektor herausgenommen wird, wobei dann sich zwischen den Elektrodenpixeln das Material der Struktur befindet und somit die Zwischenräume zwischen den Elektrodenpixeln ausfüllt). Die Zwischenräume haben hierbei dann, wie auch sonst in der ersten, pixelierten Elektrodenschicht, eine Höhe, welche der Höhe der Elektrodenpixel (auch als Pixelelektroden bezeichnet) entspricht. Die Elektrodenpixel können hierbei einen Füllungsfaktor der Struktur (also in den nicht durch das Material der Struktur gefüllten Bereichen der Struktur) von beispielsweise bis zu 90% aufweisen, bevorzugt jedoch <50%, bevorzugt<10%, mehr bevorzugt< 2%.

Es ist beispielsweise eine Größe bzw. ein Pitch eines Elektrodenpixels von 150 µm oder mehr, eine Breite der Struktur von 50 µm und weniger und/oder eine Höhe der Struktur von bis zu 1250 µm möglich.

Das Material der Struktur ist ebenfalls nicht besonders beschränkt, ist bevorzugt jedoch elektrisch isolierend, um einen Kurzschluss zwischen einzelnen Elektrodenpixeln zu vermeiden. Das Material der Struktur kann hierbei auch von der Herstellung der Struktur selbst abhängen. Wie oben beschrieben kann das Material der Struktur auch dem Material der Zwischenräume und ggf. auch eines Substrats entsprechen, kann aber auch verschieden sein, beispielsweise bei einer Auftragung von Material wie beim 3D-Drucken oder der Auftragung von Lacken.

So ist eine beispielhafte Herstellung der Struktur durch die Auftragung von Lacken, beispielsweise Photolacken, möglich, welche durch Formen und/oder Masken geeignet strukturiert und ggf. auch mehrmals aufgetragen werden können. Die Lacke, beispielsweise Photolacke, sind nicht besonders beschränkt. Durch eine geeignete Auswahl der Lacke, beispielsweise Photolacke, kann auch eine Haftung der ersten Schicht und insbesondere des mindestens einen ersten Perowskiten an der Struktur beeinflusst werden. Dies schließt auch ein Benetzungsverhalten des Materials der ersten Schicht und insbesondere des mindestens einen ersten Perowskits ein, falls dieser bei einem erfindungsgemäßen Verfahren zur Rekristallisation zumindest teilweise verflüssigt wird. Entsprechendes gilt auch für andere Materialien bei anderen Herstellungsverfahren, wie oben erwähnt.

Die verschiedenen Photolacke sind nicht besonders beschränkt und können beispielsweise sowohl positive wie negative oder andere strukturierbare Materialien sein. Beispiele für positive Photolacke bzw. Photoresists sind z.B. AZ 10XT, AZ 12XT, AZ 40XT, AZ 4533, AZ 4562, AZ 9245, AZ 9260, AS IPS 6050, AZ P4110, AZ P4260, AZ P4903 und PL 177 der Firma Microchemicals GmbH, und Beispiele für negative Photolacke z.B. AZ 125nXT, AZ 125 nXT (115CPS), AZ 15nXT (450CPS), AZ nLof 2020, AZ nLof 2035, AZ nLof 2070 und AZ nLof 5510 der Firma Microchemicals GmbH. Weitere Beispiele für Photolacke sowie Verfahren zu deren Strukturierung sind in B. Loechel, "Thick-layer resists for surface micromachining", J. Micromech. Microeng. 10, 2000, 108-115 genannt. Als weiteres Beispiel für einen Photolack ist SU-8 zu nennen, beispielsweise in A. del Campo und C. Greiner, "SU-8: a photoresist for high-aspect-ratio and 3D submicron lithography", J. Microchem. Microeng. 17, 2007, R81-R95 beschrieben.

Die erste Schicht umfassend mindestens einen ersten Perowskit ist ebenfalls nicht besonders beschränkt. Die Menge an erstem Perowskit in der ersten Schicht ist auch nicht besonders beschränkt. Gemäß bestimmten Ausführungsformen umfasst die erste Schicht den mindestens einen ersten Perowskit in einer Menge von ≥ 30 Gew.%, ≥ 50 Gew.%, oder ≥ 70 Gew.%, bezogen auf die erste Schicht, oder besteht im Wesentlichen aus dem ersten Perowskit (z.B. ≥ 90 Gew.%, ≥ 95 Gew.%, oder ≥ 99 Gew.%, bezogen auf die erste Schicht); oder besteht sogar aus dem mindestens einen ersten Perowskit.

In der ersten Schicht ist der mindestens eine erste Perowskit nicht besonders beschränkt, und es können ein Perowskit oder eine Mehrzahl von Perowskiten, beispielsweise 2, 3, 4, 5 oder mehr Perowskite umfasst sein. Gemäß bestimmten Ausführungsformen umfasst die erste Schicht einen Perowskit.

Der erste Perowskit ist nicht besonders beschränkt. Beispielsweise können sowohl organisch-anorganische als auch rein anorganische Perowskite mit einer ABX₃-Struktur, mit einem oder mehreren Kationen (A⁺), einem oder mehr B⁺-Kationen und einem oder mehr Halogeniden X⁻ Anwendung finden, welche nicht besonders beschränkt sind. Beispiele geeigneter Perowskite als erster Perowskit sind gemäß bestimmten Ausführungsformen MAPbI₃ (CH₃NH₃PbI₃), MAPbBr₃ (CH₃NH₃PbBr₃), FAPbI₃ (HC(NH₂)₂PbI₃), MAPbICl₂ (CH₃NH₃PbICl₂), FAPbBr₃ (HC (NH₂)₂PbBr₃) , EAPbI₃ (CH₃CH₂NH₃PbI₃), PAPbI₃ (CH₃CH₂CH₂NH₃PbI₃), BA₂PbI₄ ((CH₃CH₂CH₂CH₂NH₃)₂PbI₄), PMA₂PbI₄ ((C₆H₅CH₂NH₃)₂PbI₄), PEA₂PbI₄ ((C₆H₅CH₂CH₂NH₃)₂PbI₄), EAPbBr₃ (CH₃CH₂NH₃PbBr₃), PAPbBr₃ (CH₃CH₂CH₂NH₃PbBr₃) ; Mischhalogenide derselben; anorganisch-organische Perowskite mit einer Mischung von A-Kationen mit Halogeniden X (X =C l, I, und/oder Br), wie beispielsweise MAFAPbX₃ (MA = CH₃NH₃, FA = HC(NH₂)₂), MAGAPbX₃ (GA = Guanidinium), BAPAPbX₃ (BA = CH₃CH₂CH₂CH₂NH₃, PA = CH₃CH₂CH₂NH₃); organisch halogenierte Mischungen, bei denen die Halogene teilweise durch andere Halogene ersetzt sind (z.B. mit Halogeniden der Formel I₃-xClx oder Br3-xClx, etc., z.B. MAPbI₃-xClx oder CH₃NH₃PbBr₃-xClx); organische und/oder organisch-anorganische Perowskite, bei denen Pb zumindest teilweise oder sogar vollständig durch Sn, Cu, Ni, Bi, Co, Fe, Mn, Cr, Cd, Ge und/oder Yb substituiert ist, und/oder Mischungen davon; anorganische Perowskite und Mischungen davon, beispielsweise CsPbX₃, wobei X = Cl, Br, und/oder I, sowie Mischungen davon, Cs₃Bi₂X₉, wobei X = Cl, Br, und/oder I, sowie Mischungen davon, Cs₃Sb₂X, wobei X = Cl, Br, und/oder I, sowie Mischungen davon, Cs₂AgBiX₆, wobei X = Cl, Br, und/oder I, sowie Mischungen davon, Rb₃Bi₂X₉, wobei X = Cl, Br, und/oder I, sowie Mischungen davon, Rb₃Sb₂X₉, wobei X = Cl, Br, und/oder I, sowie Mischungen davon, CsSnI₃; etc., sowie Mischungen der Perowskite.

Die Schichtdicke der ersten Schicht ist nicht besonders beschränkt und kann kleiner oder größer sein als die Höhe der Struktur, auf der und in die die erste Schicht auf- und eingebracht ist. So die Schichtdicke kleiner ist als die Höhe der Struktur, ist die erste Schicht vollständig in die Struktur eingebracht, und einzelne Teile der ersten Schicht sind voneinander durch die Struktur getrennt. Die erste Schicht kann beispielsweise eine Dicke von 0,5 bis 1500 µm, bevorzugt 1 bis 1000 µm, weiter bevorzugt 3 bis 300 µm, noch weiter bevorzugt 4 bis 200 µm, insbesondere 5 bis 100 µm, weiter bevorzugt 7 bis 70 µm, noch mehr bevorzugt 10 bis 50 µm, aufweisen.

Die erste Schicht dient gemäß bestimmten Ausführungsformen zu einer physikalischen Kontaktierung zwischen der ersten und zweiten Elektrode, ggf. mit weiteren Schichten, sowie ggf. auch als Detektionsschicht, in der Elektronen-Loch-Paare erzeugt werden, so beispielsweise keine weitere Detektionsschicht vorhanden ist. Hierzu ist sie auch in der Struktur eingebracht. Durch die Struktur wird hierbei eine verbesserte Haftung der ersten Schicht umfassend mindestens einen ersten Perowskit und insbesondere des ersten Perowskiten auf der ersten, pixelierten Elektrode oder ggf. umfassten weiteren Schichten ermöglicht.

Die erste Schicht umfassend den mindestens einen ersten Perowskit ist zumindest teilweise in der Struktur eingebracht. Insbesondere kontaktiert sie gemäß bestimmten Ausführungsformen die Elektrodenpixel der ersten, pixelierten Elektrodenschicht, oder eine ggf. weiter eingebrachte Schicht, welche so einen indirekten Kontakt zur ersten, pixelierten Elektrodenschicht erzeugen kann.

Die Einbringung der ersten Schicht in die Struktur ist nicht besonders beschränkt, und sie kann derart eingebracht sein, dass sie die Struktur nur teilweise füllt, sie kann derart eingebracht sein, dass sie die Struktur genau füllt, also mit einer Oberkante oder einem obersten Punkt der Struktur abschließt, oder sie kann derart eingebracht sein, dass sie über die Struktur hinausgeht, also diese füllt und zudem teilweise oder vollständig bedeckt. Auch kann die Form der Einbringung, also die Füllung bei nicht vollständiger Füllung, vom Material der Struktur abhängig sein, wie oben beschrieben.

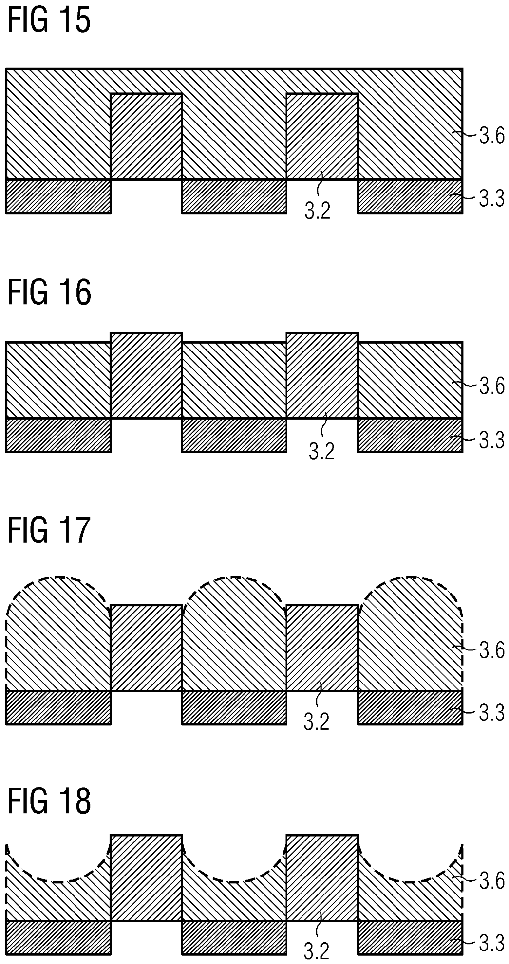

Verschiedene Beispiele für solche verschiedenen Füllungen sind in Figuren 15 bis 18 gezeigt. Gezeigt sind hierbei Elektrodenpixel 3.3 mit der Struktur 3.2 sowie der ersten Schicht 3.6, welche beispielsweise einen rekristallisierten ersten Perowskit umfasst, wie nachstehend erläutert. Eine Variante ist, dass die erste Schicht 3.6 eine größere Höhe als die Struktur 3.2 besitzt, wie in Figur 15 gezeigt, wobei eine andere Variante, die in Figur 16 gezeigt ist, eine geringere Höhe der ersten Schicht 3.6 als die Struktur 3.2 aufweist. Zusätzlich können die erste Schicht 3.6 eine positive Wölbung (Figur 17) besitzen, oder eine negative, wie in Figur 18 dargestellt. Dies hängt beispielsweise vom Benetzungsverhalten (hydrophob, hydrophil) der Struktur und/oder der ersten, pixelierten Elektrodenschicht, beispielsweise der Elektrodenpixel, ab.

Gemäß bestimmten Ausführungsformen ist der mindestens eine erste Perowskit in der ersten Schicht umfassend mindestens einen ersten Perowskit zumindest teilweise rekristallisiert und insbesondere rekristallisiert. Hierdurch kann die erste Schicht besser mit der Struktur verbunden werden.

Das Rekristallisieren ist hierbei nicht besonders beschränkt. Insbesondere unterscheidet sich der rekristallisierte erste Perowskit von einem nicht rekristallisierten ersten Perowskit, da sich die Kristallstruktur beim Rekristallisieren ändert. Entsprechend kann eine entsprechende erste Schicht mit zumindest teilweise oder vollständig rekristallisiertem Perowskit (hier auch rekristallisierte Schicht genannt) leicht von einer anderen Schicht mit demselben Perowskit, beispielsweise einer zweiten Schicht (hier auch Absorberschicht genannt), in der dieser nicht rekristallisiert ist, unterschieden werden, weil die Schichten eine unterschiedliche Morphologie aufweisen, die einfach mit Röntgenelektronenmikroskopie (REM) oder Transmissionselektronenmikroskopie (TEM) anhand von Bilder zu erfassen ist. Auch Röntgenbeugungs- (XRD) Spektren der Schichten weisen Unterschiede auf.

Eine Rekristallisation kann auf verschiedene Art und Weise erfolgen, beispielsweise durch Schmelzen unter Verwendung von Methylamin-Gas, insbesondere bei Perowskiten, welche Methylammonium-Ionen enthalten, durch Druck und/oder Temperatur, wobei die Verfahren auf den verwendeten Perowskit angepasst werden können. Beispielsweise umfasst der erste Perowskit Alkylammoniumionen, insbesondere mit 1 - 4 C-Atomen, weiter bevorzugt Methylammoniumionen, und die Behandlung zur Herstellung einer ersten Schicht erfolgt mit einem Gas umfassend Methylamin, insbesondere mit Methylamin-Gas.

Die Behandlung von Perowskiten, die Methylammonium-Ionen enthalten, mittels Methylamin (MA)-Gas ist bereits im Jahr 2017 von Li et al. publiziert worden (Li, C., S. Pang, H. Xu und G. Cui. Methylamine gas based synthesis and healing process toward upscaling of perovskite solar cells: Progress and perspective. Solar RRL, 1(9), 1700076 (2017).). In ihrem Paper beschreiben sie die Verflüssigung der zuvor festen Perowskitschicht nach der Einwirkung von MA-Gas und die anschließende Rekristallisierung mit einer veränderten Morphologie, sobald das MA-Gas nicht mehr in der Atmosphäre enthalten ist. Das Patent EP 3304611 B1 bedient sich diesem Phänomen, um einen Perowskit aus Präkursoren (u.a. einem Metallhalogenid), die auf zwei verschiedenen Oberflächen aufgetragen wurden, herzustellen. In der CN 10209088003 A ist ein Prozess beschrieben, bei dem ein einkistallines Perowskit-Pulver auf eine mesoporöse Schicht, wie zum Beispiel Titanoxid, aufgetragen und mittels MA-Gas verflüssigt wird. Als flüssige Metaphase dringt das Perowskit in die Poren ein und rekristallisiert dort.

Insbesondere ist Behandlung mit MA-Gas bevorzugt, da es technisch einfach handhabbar ist und nur geringe Mengen an MA-Gas (z.B. in einer Kammer mit Unterdruck mit einem Druck des MA-Gases von 10⁻⁶ mbar bis 10 bar, z.B. in einer Kammer mit einem Volumen von 1 L (beispielsweise 0,25 g MA-Gas bei 200 mbar Druck)) erforderlich sind, was Kosten spart.

Die erste Schicht kann hierbei auch schichtweise mehrfach aufgebracht und rekristallisiert werden. Die erste Schicht umfassend mindestens einen ersten verflüssigten und rekristallisierten Perowskit kann hier insbesondere als Haftvermittler zwischen der ersten, pixelierten Elektrodenschicht oder einer optional anderen, darauf aufgebrachten Schicht wie einer Elektronenleiter- oder Lochleiterschicht und einer ggf. weiteren, zweiten oder dritten Schicht dienen, wobei die zweite oder dritte Schicht hier als eine dicke Absorberschicht, beispielsweise als eine dicke Perowskit-Absorberschicht im Falle einer zweiten Schicht umfassend mindestens einen zweiten Perowskiten, dient. Die Struktur dient hier also indirekt zur Vergrößerung der Ankeroberfläche für die finale Anbindung der zweiten und/oder dritten Schicht, wobei die zweite und/oder dritte Schicht üblicherweise besser auf der ersten Schicht haften als auf der ersten, pixelierten Elektrodenschicht. Durch eine solche Anbindung kann insbesondere einfach eine kritische Absorberschichtdicke hergestellt werden, welche insbesondere bei Röntgen- und/oder Gammadetektoren erforderlich ist. Es ist ein Schicht-zu-Schicht Aufbau möglich, wobei hier dann eine separate, zweite und/oder dritte Schicht - die in einem separaten Prozess hergestellt werden kann, beispielsweise durch Walzen, Sintern, etc., beispielsweise mit größerer Schichtdicke, aufgebracht werden kann.

Gemäß bestimmten Ausführungsformen füllt die erste Schicht umfassend mindestens einen ersten Perowskit zumindest die Struktur. Hierdurch kann dann eine verbesserte Anbindung an weitere Schichten erfolgen, beispielsweise eine zweite oder dritte Schicht oder die zweite Elektrode, eine optionale elektronenleitende oder lochleitende Schicht, etc.

Gemäß bestimmten Ausführungsformen umfasst ein erfindungsgemäßer Detektor für elektromagnetische Strahlung weiter eine zweite Schicht umfassend mindestens einen zweiten Perowskit, welche sich zwischen der ersten Schicht umfassend mindestens einen ersten Perowskit und der zweiten Elektrode befindet, und/oder weiter umfassend eine dritte Schicht umfassend mindestens einen Szintillator, welche sich zwischen der ersten Schicht umfassend mindestens einen ersten Perowskit und der zweiten Elektrode befindet.

Gemäß bestimmten Ausführungsformen umfasst ein erfindungsgemäßer Detektor für elektromagnetische Strahlung weiter eine zweite Schicht umfassend mindestens einen zweiten Perowskit, welche sich zwischen der ersten Schicht umfassend mindestens einen ersten Perowskit und der zweiten Elektrode befindet.

Die zweite Schicht umfassend mindestens einen zweiten Perowskit ist nicht besonders beschränkt. Die Menge an zweitem Perowskit in der zweiten Schicht ist auch nicht besonders beschränkt. Gemäß bestimmten Ausführungsformen umfasst die zweite Schicht den mindestens einen zweiten Perowskit in einer Menge von ≥ 30 Gew.%, ≥ 50 Gew.%, oder ≥ 70 Gew.%, bezogen auf die zweite Schicht, oder besteht im Wesentlichen aus dem zweiten Perowskit (z.B. ≥ 90 Gew.%, ≥ 95 Gew.%, oder ≥ 99 Gew.%, bezogen auf die zweite Schicht); oder besteht sogar aus dem mindestens einen zweiten Perowskit.

Die zweite Schicht stellt insbesondere eine Absorberschicht für die die elektromagnetische Strahlung dar. Gemäß bestimmten Ausführungsformen weist sie eine Dicke (in Richtung zwischen der ersten, pixelierten Elektrodenschicht und der zweiten Elektrode) von 5 bis 5000 µm, bevorzugt 10 bis 3000 µm, weiter bevorzugt 50 bis 2000µm, noch weiter bevorzugt 100 bis 1500 µm auf. Die zweite Schicht kann als separate Schicht hergestellt werden, beispielsweise als separat hergestellte Perowskitschicht, und kann sowohl freistehend als auch nicht freistehend sein, also beispielsweise auch bei der Herstellung in Kontakt mit der zweiten Elektrode oder einer optionalen elektronenleitenden oder lochleitenden Schicht sein, z.B. in Kontakt mit einer ITO oder FTO-Elektrode, wobei die zweite Elektrode auch beispielweise auf einer transparenten Oberflächenschicht wie einem Glas sein kann.

Die Zusammensetzung der zweiten Schicht muss hinsichtlich der Verbindungen nicht der Zusammensetzung der ersten Schicht entsprechen, kann aber dieser entsprechen. Insbesondere können der mindestens eine erste und der mindestens eine zweite Perowskit gleich oder verschieden sein. Gemäß bestimmten Ausführungsformen entspricht der mindestens eine erste Perowskit dem mindestens einen zweiten Perowskit. Hierdurch können Verluste bei der Detektion, beispielsweise hinsichtlich einem Auslesesignal oder thermischen Spannungen durch die Prozessierung, etc., vermieden werden.

Gemäß bestimmten Ausführungsformen ist die zweite Schicht in Kontakt mit der ersten Schicht und/oder der Struktur und ist insbesondere in Kontakt mit der ersten Schicht. Durch die Verwendung von Perowskiten in beiden Schichten kann eine gute Haftung erzielt werden.

Gemäß bestimmten Ausführungsformen umfasst ein erfindungsgemäßer Detektor für elektromagnetische Strahlung weiter eine dritte Schicht umfassend mindestens einen Szintillator, welche sich zwischen der ersten Schicht umfassend mindestens einen ersten Perowskit und der zweiten Elektrode befindet.

Die dritte Schicht ist hierbei nicht besonders beschränkt. Gemäß bestimmten Ausführungsformen weist sie eine Dicke (in Richtung zwischen der ersten, pixelierten Elektrodenschicht und der zweiten Elektrode) von 5 bis 5000 µm, bevorzugt 10 bis 3000 µm, weiter bevorzugt 50 bis 2000 µm, noch weiter bevorzugt 100 bis 1500 µm auf. Die dritte Schicht kann als separate Schicht hergestellt werden, beispielsweise als separat hergestellte Szintillatorschicht, und kann sowohl freistehend als auch nicht freistehend sein, also beispielsweise auch bei der Herstellung in Kontakt mit der zweiten Elektrode oder einer optionalen elektronenleitenden oder lochleitenden Schicht sein, z.B. in Kontakt mit einer ITO oder FTO-Elektrode, wobei die zweite Elektrode auch beispielweise auf einer transparenten Oberflächenschicht wie einem Glas sein kann.

Gemäß bestimmten Ausführungsformen ist die dritte Schicht in Kontakt mit der ersten Schicht und/oder der Struktur und ist insbesondere in Kontakt mit der ersten Schicht.

In Ausführungsformen mit erster und dritter Schicht dient insbesondere die dritte Schicht als Detektionsschicht für hochenergetische Strahlung, beispielsweise Röntgen- und/oder Gammastrahlung, und die erste Schicht dient der indirekten Detektion durch die Konversion von Photonen, die in der dritten Schicht erzeugt werden.

Der Szintillator der dritten Schicht ist nicht besonders beschränkt. Beispielsweise sind CsI:Tl, mit Thallium dotiertes Cäsiumiodid, mit Terbium dotiertes Gadoliniumoxysulfid, Bariumfluorid (BaF₂), Bismutgermanat (BGO), Berylliumfluorid (BeF₃), Quantendots, szintillierende Perowskit-Nanokristalle, etc., als Szintillator geeignet.

Gemäß bestimmten Ausführungsformen ist die zweite Schicht umfassend den mindestens einen zweiten Perowskit umfasst, wobei der mindestens eine zweite Perowskit zumindest teilweise nicht rekristallisiert ist. Für die zweite Schicht ist keine Rekristallisation erforderlich, da diese auf einfachere Weise hergestellt werden kann, beispielsweise durch Sintern oder Walzen.

Gemäß bestimmten Ausführungsformen umfasst ein erfindungsgemäßer Detektor für elektromagnetische Strahlung weiter eine elektronenleitende und/oder eine lochleitende Schicht, welche sich zwischen der ersten, pixelierten Elektrodenschicht und der zweiten Elektrode befindet. Es können auch mehrere elektronenleitende und/oder lochleitende Schichten im Detektor umfasst sein.

Die elektronenleitende und/oder lochleitende Schicht ist hierbei nicht besonders beschränkt, und es können nur eine elektronenleitende Schicht, nur eine lochleitende Schicht oder eine elektronen- und eine lochleitende Schicht im erfindungsgemäßen Detektor vorhanden sein. Eine elektronenleitende und/oder lochleitende Schicht stellt hierbei eine Zwischenschicht dar, welche auch als Interlayer bezeichnet wird. Ein Interlayer ist entsprechend eine Zwischenschicht, die entweder als Elektrontransport- (bzw. Loch-blockierende (HBL)) Schicht, also als elektronenleitende Schicht, oder als Lochtransport-(bzw. Elektronen-blockierende (EBL)) Schicht, also als lochleitende Schicht funktioniert.

Die Materialien für solche elektronenleitende und/oder lochleitende Schichten sind nicht besonders beschränkt, und es können solche zur Anwendung kommen, welche in üblichen elektronenleitenden und/oder lochleitenden Schichten zur Anwendung kommen.

Eine beispielhafte elektronenleitende Schicht (HBL) kann beispielsweise die folgenden Materialien umfassen z.B. mit ≥ 30 Gew.%, ≥ 50 Gew.%, oder ≥ 70 Gew.%, bezogen auf die elektronenleitende Schicht; im Wesentlichen aus diesen bestehen (z.B. ≥ 90 Gew.%, ≥ 95 Gew.%, oder ≥ 99 Gew.%, bezogen auf die elektronenleitende Schicht); oder sogar aus diesen bestehen (wobei die folgende Liste nicht abschließend ist und zudem Mischungen und isomere Mischungen der genannten Materialien umfasst, beispielsweise auch binäre, ternäre, quaternäre Mischungen, etc.):
Fulleren-Derivate wie C60 PCBM ([6,6]-Phenyl C61 Butansäuremethylester), C70 PCBM ([6,6]-Phenyl C71 Butansäuremethylester), Bis-C60 PCBM (Bis-[6,6]-phenyl C61 Butansäuremethylester), C60 oQDM (o-Chinodimethan C60 Monoaddukt), Bis C60-OQDM (o-Chinodimethan C60 Bisaddukt), ICMA (Inden C60 Monoaddukt, ICBA (Inden C60 Bisaddukt), Fullerol (C60(OH)44);
weitere Akzeptoren, umfassend polymere und kleine Moleküle, wie: Dithienoindacen-basierte Verbindungen wie 3,9-bis(2-methylen-(3-(1,1-dicyanomethylen)-indanon))-5,5,11,11-tetrakis(4-hexylphenyl)-dithieno[2,3-d:2',3'-d']-s-indaceno[1,2-b:5,6-b']dithiophen) (ITIC), IT-M (ITIC-M; 3,9-Bis(2-methylen-((3-(1,1-dicyanomethylen)-6/7-methyl)-indanon))-5,5,11,11-tetrakis(4-hexylphenyl)-dithieno[2,3-d:2',3'-d']-s-indaceno[1,2-b:5,6-b']dithiophen), IT-DM (ITIC-DM; 3,9-Bis(2-methylen-((3-(1,1-dicyanomethylen)-6,7-dimethyl)-indanon))-5,5,11,11-tetrakis(4-hexylphenyl)-dithieno[2,3-d:2',3'-d']-s-indaceno[1,2-b:5,6-b']dithiophen) und IDTBR ((5Z,5'Z)-5,5'-((7,7'-(4,4,9,9-Tetraoctyl-4,9-dihydro-s-indaceno[1,2-b:5,6-b']dithiophen-2,7-diyl)bis(benzo[c][1,2,5]thiadiazol-7,4-diyl))bis(methanylyliden))bis(3-ethylthiazolidin-2,4-dion)); Perylendiimid-basierte Verbindungen wie TPB (tert-Butylprydin, C₉H₁₃N), SdiPDI-Se (Perylendiimid-Derivat modifiziert durch die Insertion von Selenophen-Einheiten in die Buchtposition (bay position)), NIDCS-HO ((2E,2'E)-3,3'-(2,5-Bis(hexyloxy)-1,4-phenylen)bis(2-(5-(4-(N-(2-ethylhexyl)-1,8-naphthalimid)yl)-thiophen-2-yl)acrylonitril)); Diketopyrrolopyrrol-basierte Verbindungen wie DPP6 (Dipeptidylaminopeptidase-like protein 6), 6,6'-(Benzo[c][1,2,5]thiadiazole-4,7-diylbis([2,2'-bithiophen]-5',5-diyl))bis(2,5-bis(2- ethylhexyl)-3-(thiophen-2-yl)-2,5-dihydropyrrolo[3,4-c]pyrrol-1,4-dion) (DTDfBT(DPP)2), 6,6',6",6‴-(9,9'-Spirobi[fluoren]-2,2',7,7'-tetrayltetrakis(thiophen-5,2- diyl))tetrakis(2,5-bis(2-ethylhexyl)-3-(5-phenylthiophen-2-yl)-2,5-dihydropyrrolo[3,4- c]pyrrol-1,4-dion) (SF(DPPB)4); PFN (Poly[(9,9-bis(3'-(N,N-dimethylamino)-propyl)-2,7-fluoren)-alt-2,7-(9,9-dioctylfluoren)]), PFN-OX (Poly[9,9-bis(60-(N,N-diethylamino)propyl)-fluoren-alt-9,9-bis-(3-ethyl(oxetan-3-ethyloxy)-hexyl)-fluoren]), PFO (Poly(9,9-di-n-octylfluorenyl-2,7-diyl)), PPDIDTT (Poly{[N,N'-bis(2-decyl-tetradecyl)-3,4,9,10-perylendiimid-1,7-diyl]-alt-(dithieno[3,2-b:2',3'-d]thiophen-2,6-diyl)}), TPBi (1,3,5-Tris(N-phenylbenzimidazol-2-yl)benzol); Metalloxide wie Ti-Oₓ, SnOₓ, etc.

Eine beispielhafte lochleitende Schicht (EBL) kann beispielsweise die folgenden Materialien umfassen z.B. mit ≥ 30 Gew.%, ≥ 50 Gew.%, oder ≥ 70 Gew.%, bezogen auf die elektronenleitende Schicht; im Wesentlichen aus diesen bestehen (z.B. ≥ 90 Gew.%, ≥ 95 Gew.%, oder ≥ 99 Gew.%, bezogen auf die elektronenleitende Schicht); oder sogar aus diesen bestehen (wobei die folgende Liste nicht abschließend ist und zudem Mischungen Mischungen der genannten Materialien umfasst, beispielsweise auch binäre, ternäre, quaternäre Mischungen, etc.): Poly(3-hexylthiophen-2,5-diyl) (P3HT), Poly[2-methoxy-5-(2-ethylhexyloxy)-1,4-phenylenvinylen] (MEH-PPV), Poly[2-methoxy-5-(3',7'-dimethyloctyloxy)-1,4-phenylenevinylene] (MDMO-PPV), CN-PPV, CN-MEH-PPV, andere Phthalocyanine, Poly[(9,9-di-n-octylfluorenyl-2,7-diyl)-alt-(benzo[2,1,3]thiadiazol-4,8-diyl)] (F8BT), Polyfluoren (PF), Poly[2,1,3-benzothiadiazol-4,7-diyl[4,4-bis(2-ethylhexyl)-4H-cyclopenta[2,1-b:3,4-b']dithiophen-2,6-diyl]] (PCPDTBT), Squaraine (z.B. symmetrische Squaraine mit z.B. endständigem Hydrazon mit glykolischer Funktionalisierung oder Diazulen-Squaraine), PTT) (Polythieno[3,4-b]thiophene), poly(5,7-bis(4-decanyl-2-thienyl)-thieno(3,4-b)diathiazole-thiophene-2,5) (PDDTT); Diketopyrrolopyrrol-basierte Polymere wie Poly{2,2'-[(2,5-bis(2-hexyldecyl)-3,6-dioxo-2,3,5,6-tetrahydropyrrolo[3,4-c]pyrrol-1,4-diyl)dithiophen]-5,5'-diyl-alt-thiophen-2,5-diyl} (PDPP3T), Poly[[2,5-bis(2-hexyldecyl-2,3,5,6-tetrahydro-3,6- dioxopyrrolo[3,4 c]pyrrol-1,4-diyl]-alt-[3',3"-dimethyl- 2,2':5',2"- terthiophen]-5,5"-diyl] (PMDPP3T), Poly{2,2'-[(2,5-bis(2-hexyldecyl)-3,6-dioxo-2,3,5,6-tetrahydropyrrolo[3,4-c]pyrrol-1,4-diyl)dithiophen]-5,5'-diyl-alt-terthiophen-2,5-diyl} (PDPP5T), Poly[2,6-4,8-di(5-ethylhexylthienyl)benzo[1,2-b;3,4- b]dithiophen-alt-5-dibutyloctyl-3,6-bis(5-bromthiophen-2-yl)pyrrolo[3,4-c]pyrrol-1,4-dion] (PBDTT-DPP); Dithienosilol-basierte Polymere wie Poly[(4,4-bis(2-ethylhexyl)dithieno[3,2-b:2',3'-d]silol)-2,6-diyl-alt-(4,7-bis(2-thienyl)-2,1,3-benzothiadiazol)-5,5'-diyl] (PSBTBT), 7,7'-(4,4-bis(2-ethylhexyl)-4H-silol[3,2-b:4,5-b']dithiophen-2,6-diyl)bis(6-fluoro-4-(5'-hexyl-[2,2'-bithiophen]-5-yl)benzo[c][1,2,5]thiadiazol) (p-DTS(FBTTh2)2), Poly[2,7-(9,9-dioctyl-dibenzosilol)-alt-4,7-bis(thiophen-2-yl)benzo-2,1,3-thiadiazol] (PSiFDTBT); Benzodithiophen-basierte Polymere wie Poly[4,8-bis[(2-ethylhexyl)oxy]benzo[1,2-b:4,5-b']dithiophen-2,6-diyl-alt-3-fluoro-2-[(2-ethylhexyl)carbonyl]thieno[3,4-b]thiophen-4,6-diyl] (PTB7), Poly[(2,6-(4,8-bis(5-(2-ethylhexyl)thiophen-2-yl)-benzo[1,2-b:4,5-b']dithiophen))-alt-(5,5-(1',3'-di-2-thienyl-5',7'-bis(2-ethylhexyl)benzo[1',2'-c:4',5'-c']dithiophen-4,8-dion))]) (PBDB-T), Poly{2,6'-4,8-di(5-ethylhexylthienyl)benzo[1,2-b;3,4-b]dithiophen-alt-5-dibutyloctyl-3,6-bis(5-bromothiophen-2-yl)pyrrolo[3,4-c]pyrrol-1,4-dion (PBDTT-DPP), Poly[4,8-bis(5-(2-ethylhexyl)thiophen-2-yl)benzo[1,2-b;4,5-b']dithiophen-2,6-diyl-alt-(4-(2-ethylhexyl)-3-fluorothieno[3,4-b]thiophen-)-2-carboxylat-2-6-diyl)] (PBDTT-FTTE), Poly[(4,8-bis-(2-ethylhexyloxy)-benzo(1,2-b:4,5-b')dithiophen)-2,6-diyl-alt-(4-(2-ethylhexanoyl)-thieno[3,4-b]thiophen-)-2-6-diyl)] (PBDTTT-C-F), PolyBenzoThiadiaZol(Thiophen)-stat-BenzoDiThiophen(Thiophen)-8 (PBTZT-stat-BDTT-8) und andere Polymere und Copolymere und kleine Moleküle mit Absorptionsmaximum zwischen 320-800 nm; Polytriarylamine und Derivate, Poly[[2,5-bis(2-octyldo-decyl)-2,3,5,6-tetrahydro-3,6-dioxopyrrolo[3,4-c]pyrrol-1,4-diyl]-alt2[[2,2'-(2,5-thiophen)bisthieno[3,2-b]thiophen]-5,5'-diyl]] (DPP(P)), Polyanilin (PANI), Poly[(4,8-bis-(2-ethylhexyloxy)-benzo(1,2-b:4,5-b')dithiophen)-2,6-diyl-alt-(4-(2-ethylhexanoyl)-thieno[3,4-b]thiophen)-2-6-diyl)] (PBDTTT-C), Poly[N29-hepta-decanyl-2,7-carbazol-alt-3,6-bis-(thiophen-5-yl)-2,5-dioctyl-2,5-dihydropyrrolo[3,4-]pyrrol-1,4-dion] (PCBTDPP), Poly[[9-(1-octylnonyl)-9H-carbazol-2,7-diyl]-2,5-thiophendiyl-2,1,3-benzothiadiazol-4,7-diyl-2,5-thiophendiyl] (PCDTBT), Poly[2,5-bis(2-octyldodecyl)pyrrolo[3,4-c]pyrrol-1,4(2H,5H)-dion-(E)-1,2-di(2,2'-bithiophen-5-yl)ethen] (PDPPDBTE), Perfluoro(4-methyl-3,6-dioxaoct-7-en)sulfonylfluorid (PFI), Poly(4-styrolsulfonat)-graft-polyanilin (PSS-g-PANI), Copolymer aus 2'-Butyloctyl-4,6-dibromo-3-fluorothieno[3,4-b]thiophen-2-carboxylat (TT-BO), Copolymer aus 3',4'-Dichlorobenzyl-4,6-dibromo-3-fluorothieno-[3,4-b]thiophen-2-carboxylat (TT-DCB) und 2,6-Bis(trimethyl-zinn)-4,8-bis(2-ethylhexyloxy)benzo[1,2-b:4,5-b']dithiophen (BDT-EH) (PTB-DCB21); N2,N2,N2`,N2`,N7,N7,N7',N7'-Octakis(4-methoxyphenyl)-9,9'-spirobi[9H-fluoren]-2,2',7,7'-tetramin (spiro-OMeTAD), Poly[(9,9-dioctylfluorenyl-2,7-diyl)-co-(4,4'-(N-(4-sec-butylphenyl)diphenylamin)] (TFB), N4,N4'-Di(naphthalen-1-yl)-N4,N4`-bis(4-vinylphenyl)biphenyl-4,4`-diamin (VNPB), 1,4-Bis(4-sulfonatobutoxy)benzol und Thiophenanteil (PhNa-1T)); Metalloxide wie NiOₓ,MoOₓ, etc.

Eine elektronenleitende und/oder eine lochleitende Schicht kann beispielsweise zwischen der ersten, pixelierten Elektrodenschicht und der ersten Schicht, zwischen der ersten Schicht und der optionalen zweiten und/oder dritten Schicht, wobei dies weniger bevorzugt ist, zwischen einer optionalen zweiten und einer optionalen dritten Schicht (weniger bevorzugt) und/oder zwischen der optionalen zweiten Schicht und der zweiten Elektrode vorgesehen sein.

Gemäß bestimmten Ausführungsformen umfasst ein erfindungsgemäßer Detektor für elektromagnetische Strahlung weiter ein Substrat, auf welchem sich die erste, pixelierte Elektrodenschicht befindet, wobei das Substrat bevorzugt eine Vielzahl von Transistoren aufweist, wobei weiter bevorzugt jeweils mindestens ein Transistor ein Elektrodenpixel der ersten, pixelierten Elektrodenschicht kontaktiert.

Das Substrat ist nicht besonders beschränkt und kann beispielsweise ein pixeliertes Substrat sein. Insbesondere dient das Substrat zur Kontaktierung der Elektrodenpixel und/oder zur Stabilisierung des Detektors, vereinfacht aber auch dessen Herstellung. Das Substrat kann ein solches sein, welches gewöhnlich in Detektoren, insbesondere Röntgen- und/oder Gammadetektoren, vorkommt.

Auch die Transistoren sind nicht besonders beschränkt und können beispielsweise TFT sein. Es können auch mehrere Transistoren ein Elektrodenpixel kontaktieren.

Gemäß bestimmten Ausführungsformen kann sich auf der zweiten Elektrode noch eine Oberflächenschicht, beispielsweise ein Glas und/oder eine Verkapselung, befinden.

Ein erfindungsgemäßer Detektor ist insbesondere flächig ausgestaltet. Für den erfindungsgemäßen Detektor sind insbesondere einfache Lösungen wie der Einsatz von Anisotropic Conductive Films (ACF) oder Conductive Inks nicht einsetzbar, weil eine "flächige" Kontaktierung per Elektrodenpixel zur ersten Schicht gewährleistet werden muss, und nicht eine punktuelle. Flächig bedeutet hier gemäß bestimmten Ausführungsformen eine Kontaktierung der Fläche der ersten Schicht pro Elektrodenpixel, die größer als 60% der Fläche der Elektrodenpixel ist, bevorzugt >80%, weiter bevorzugt >90%, z.B. mehr als 95%, mehr als 99%, oder sogar 100%.

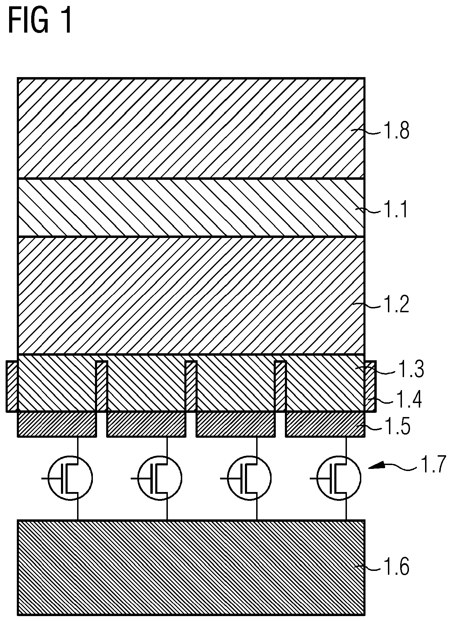

Ein beispielhafter erfindungsgemäßer Detektor ist schematisch in Figur 1 gezeigt, wobei dort eine beispielhafte Schichtanordnung gezeigt ist, hier beispielsweise eines Röntgen- und/oder Gammadetektors. Das Substrat 1.6 umfasst Transistoren 1.7, beispielsweise Dünnfilmtransistoren (TFTs) in einem Active Matrix Driving Scheme. Die Transistoren 1.7 kontaktieren die Elektrodenpixel 1.5, die eine strukturierte erste, pixelierte Elektrodenschicht bilden. Zwischen den Elektrodenpixeln 1.5 sind Zwischenräume, über denen sich eine Struktur 1.4 befindet, hier beispielsweise als Gitter für eine Ankerstruktur. In der Struktur 1.4 und darüber hinaus befindet sich eine erste Schicht 1.3 umfassend mindestens einen ersten Perowskiten, welcher rekristallisiert ist. Auf der ersten Schicht 1.3 befindet sich eine zweite Schicht 1.2 umfassend mindestens einen zweiten Perowskiten, der hier dem mindestens einen ersten Perowskit entspricht. Darüber befindet sich die zweite Elektrode 1.1 sowie eine Verkapselung 1.8.

Ergänzend zu dem in Figur 1 exemplarisch gezeigten Schichtaufbau des Detektors können sich ein oder mehrere Interlayer, also elektronen- und/oder lochleitende Schichten mit Elektronen- und/oder Loch-leitenden (Loch-/Elektronen blockierenden) Funktionen im Aufbau befinden. Mögliche Positionen für einen oder mehrere Interlayer wären beispielsweise zwischen den Elektrodenpixeln 1.5 und der ersten Schicht 1.3, zwischen der ersten Schicht 1.3 und der zweiten Schicht 1.2, wobei dies weniger bevorzugt ist, und/oder zwischen der zweiten Schicht 1.2 und der zweiten Elektrode 1.1.

Weiterhin offenbart ist ein Verfahren zur Herstellung eines Detektors für elektromagnetische Strahlung, insbesondere eines Röntgen- und/oder Gammadetektors, umfassend:
- Bereitstellen einer ersten, pixelierten Elektrodenschicht umfassend eine Vielzahl von Elektrodenpixeln sowie Zwischenräume zwischen den einzelnen Elektrodenpixeln;
- Aufbringen einer Struktur zumindest teilweise auf die Zwischenräume der ersten, pixelierten Elektrodenschicht, wobei die Struktur derart aufgebracht wird, dass die Struktur zumindest teilweise auf den Zwischenräumen zwischen den einzelnen Elektrodenpixeln von der ersten Elektrodenschicht weg angeordnet ist;
- Einbringen einer ersten Schicht umfassend mindestens einen ersten Perowskit in die Struktur; und
- Aufbringen einer zweiten Elektrode auf die Struktur und/oder die erste Schicht umfassend mindestens einen ersten Perowskit; oder
- Bereitstellen einer Struktur, wobei die Struktur Zwischenräume aufweist;
- Einbringen einer Vielzahl von Elektrodenpixel zwischen die Zwischenräume der Struktur, wobei die Elektrodenpixel die Struktur nicht füllen, und dadurch bilden einer ersten, pixelierten Elektrodenschicht;
- Einbringen einer ersten Schicht umfassend mindestens einen ersten Perowskit in die Struktur; und
- Aufbringen einer zweiten Elektrode auf die Struktur und/oder die erste Schicht umfassend mindestens einen ersten Perowskit.

Gemäß bestimmten Ausführungsformen werden die Schritte in der angegebenen Reihenfolge durchgeführt.

Mit dem erfindungsgemäßen Verfahren kann insbesondere ein erfindungsgemäßer Detektor hergestellt werden. Entsprechend beziehen sich Beschreibungen zum erfindungsgemäßen Detektor gemäß bestimmten Ausführungsformen auch auf das erfindungsgemäße Verfahren sowie vice versa. Insbesondere können die verschiedenen Schichten und Materialien zu deren Herstellung im erfindungsgemäßen Verfahren dieselben sein, welche bereits im Zusammenhang mit dem erfindungsgemäßen Detektor beschrieben wurden, sowie auch umgekehrt. Vorteilhaft ist am erfindungsgemäßen Verfahren, dass es leicht auf große Flächen (z.B. 43 x 43 cm²) skalierbar ist.

Ein erfindungsgemäßes Verfahren kann zunächst die Schritte
I) - Bereitstellen einer ersten, pixelierten Elektrodenschicht umfassend eine Vielzahl von Elektrodenpixeln sowie Zwischenräume zwischen den einzelnen Elektrodenpixeln;
   - Aufbringen einer Struktur zumindest teilweise auf die Zwischenräume der ersten, pixelierten Elektrodenschicht, wobei die Struktur derart aufgebracht wird, dass die Struktur zumindest teilweise auf den Zwischenräumen zwischen den einzelnen Elektrodenpixeln von der ersten Elektrodenschicht weg angeordnet ist;
      oder die Schritte
II) - Bereitstellen einer Struktur, wobei die Struktur Zwischenräume aufweist;
   - Einbringen einer Vielzahl von Elektrodenpixel zwischen die Zwischenräume der Struktur, wobei die Elektrodenpixel die Struktur nicht füllen, und dadurch bilden einer ersten, pixelierten Elektrodenschicht
      umfassen.

Unterschieden können die beiden Verfahren beispielsweise hinsichtlich der Herstellung der Struktur. Variante I) ist beispielsweise vorteilhaft bei Verfahren, bei denen die Struktur nachträglich aufgebracht wird, wie beispielsweise bei Lacken, insbesondere Photolacken, oder bei einem 3D-Drucken. Die Variante II) bietet sich dagegen bei Verfahren an, bei denen Teile eines Substrats, etc. entfernt werden, um eine Struktur herzustellen, wie beispielsweise bei einem Ätzen oder eine Laserabtragung, wie oben beschrieben.

Weder das Bereitstellen einer ersten, pixelierten Elektrodenschicht, die wie oben beschrieben beschaffen sein kann, noch das Bereitstellen einer Struktur in Variante II), die ebenfalls wie oben beschrieben beschaffen sein kann, beispielsweise basierend auf einem Substrat, sind besonders beschränkt. Das Aufbringen einer Struktur in Variante I) kann wie oben beschrieben beispielsweise durch Auftragen von Lack, beispielsweise Photolack, ggf. auch mehrmalig, und/oder durch 3D-Drucken, etc. erfolgen. Das Einbringen der Elektrodenpixel in Variante II kann beispielsweise durch Einbringen des Materials der Elektrodenpixel, wie oben beschrieben, in die Region zwischen den "Zwischenräumen" der ersten, pixelierten Elektrodenschicht (welche dadurch in diesen Ausführungsformen wie oben definiert werden), beispielsweise auch auf Kontaktierungen eines Substrats, und Verflüssigen und wieder Verfestigen (beispielsweise Schmelzen und wieder Erstarren), Einbringen der festen Elektrodenpixel, Verfestigen aus der Gasphase, Abdampfen aus Lösung, etc., erfolgen und ist nicht besonders beschränkt, und kann auch aus Präkursoren des Elektrodenmaterials erfolgen, beispielsweise bei einem Ausfällen.

In beiden Verfahren wird dann die erste Schicht umfassend mindestens einen ersten Perowskiten eingebracht. Auch dieser Schritt ist nicht besonders beschränkt. Beispielsweise kann das Material für die erste Schicht umfassend mindestens einen ersten Perowskiten, beispielsweise mindestens ein erstes Perowskitmaterial und/oder dessen Präkursoren, als Pulver in die Struktur eingebracht werden und dort verflüssigt und wieder erstarrt werden. Die eingebrachte Materialkomposition muss also nicht der finalen Komposition der finalen ersten Schicht entsprechen. Bei einem Einbringen von Präkursoren kann nach Herstellung des mindestens einen ersten Perowskiten dieser ebenfalls wieder verflüssigt und erstarrt werden, um ihn zu rekristallisieren. Hierbei kann der mindestens eine erste Perowskit bzw. die erste Schicht gut mit der Struktur verbunden und daran befestigt werden, da durch die Flüssigphase eine gute Benetzung erfolgen kann. Das Verflüssigen ist hierbei nicht besonders beschränkt und kann, wie oben bereits im Zusammenhang mit dem Detektor beschrieben, durch Einwirken von Methalamin-Gas (MA-Gas), Druck und/oder Temperatur erfolgen. Das Erstarren und somit Rekristallisieren kann dann entsprechend wieder durch Wegfall des MA-Gases und/oder eine weitere entsprechende Temperatur- und/oder Druckänderung erfolgen, wobei diese an den mindestens einen ersten Perowskiten angepasst sein können.

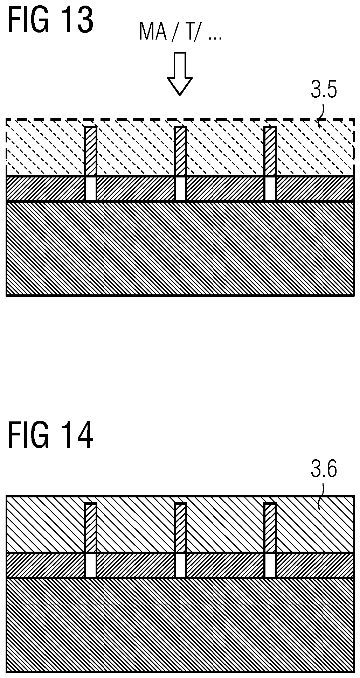

Ein entsprechendes Verfahren ist schematisch in Figuren 12 bis 14 gezeigt. Auf einem Substrat 3.4 befindet sich, wie in Figur 12 gezeigt, eine erste Elektrodenschicht 3.3 umfassend Elektrodenpixel. Über den Zwischenräumen der ersten Elektrodenschicht 3.3 befindet sich eine Struktur 3.2 als Ankerstruktur. In die Struktur 3.2 wird das Material für die erste Schicht als Pulver 3.1, beispielsweise als Perowskit-pulver oder als Präkursormaterialien für Perowskit, eingebracht und ggf. auch aufgetragen, wie hier beispielhaft in Figur 12 gezeigt. Im in Figur 13 gezeigten Schritt wird anschließend das Pulver durch Einwirkung von MA-Gas, Temperatur T, etc. verflüssigt, sodass sich eine flüssige erste Schicht 3.5 bildet. Diese wird dann im in Figur 14 gezeigten Schritt rekristallisiert, um eine rekristallisierte erste Schicht 3.6 zu bilden. Diese weist dann eine gute Adhäsion auf der ersten Elektrodenschicht 3.3 mit einer guten elektrischen Kontaktierung der einzelnen Elektrodenpixel auf deren Oberfläche auf, z.B. größer als 60% der Fläche der Elektrodenpixel, bevorzugt >80%, weiter bevorzugt >90%, z.B. mehr als 95%, mehr als 99%, oder sogar 100%.

In einem solchen Verfahren können das Auftragen der Materialien für die ersten Schicht, beispielsweise des mindestens einen ersten Perowskiten und/oder dessen Präkursoren, das Verflüssigen und das Rekristallisieren einmal oder auch mehrfach angewendet werden, um eine gewünschte Füllhöhe bzw. Dicke der ersten Schicht zu erreichen.

Alternativ kann auch nur ein Teil der ersten Schicht verflüssigt werden, z.B. mittels MA-Gas, Temperatur und/oder Druck, und dieser verflüssigte Teil mit der Struktur und bevorzugt final mit der ersten, pixelierten Elektrodenschicht in Kontakt gebracht werden, wonach dann der verflüssigte Teil der ersten Schicht rekristallisiert wird. Hierbei bildet sich nach dem Rekristallisieren eine Struktur, die einer Kombination einer ersten Schicht und einer zweiten Schicht mit gleichem Perowskitmolekül in unterschiedlicher Kristallstruktur aufweist, wie oben beschrieben, sodass sich dann auch entsprechende Schichtdicken ergeben, beispielsweise insgesamt von 5 bis 5000 µm, bevorzugt 10 bis 3000 µm, weiter bevorzugt 50 bis 2000pm, noch weiter bevorzugt 100 bis 1500 µm, sowie ggf. zusätzlich der Höhe der Struktur, die wie oben angegeben sein kann. Es wird also hier die Absorberschicht teilweise verflüssigt und direkt mit der Ankerstruktur verbunden.

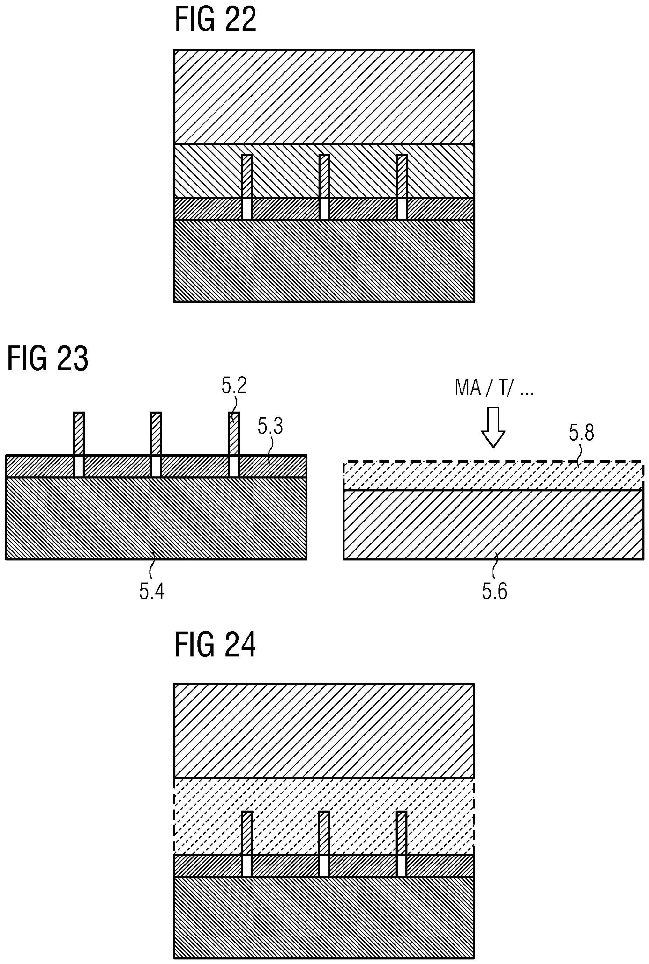

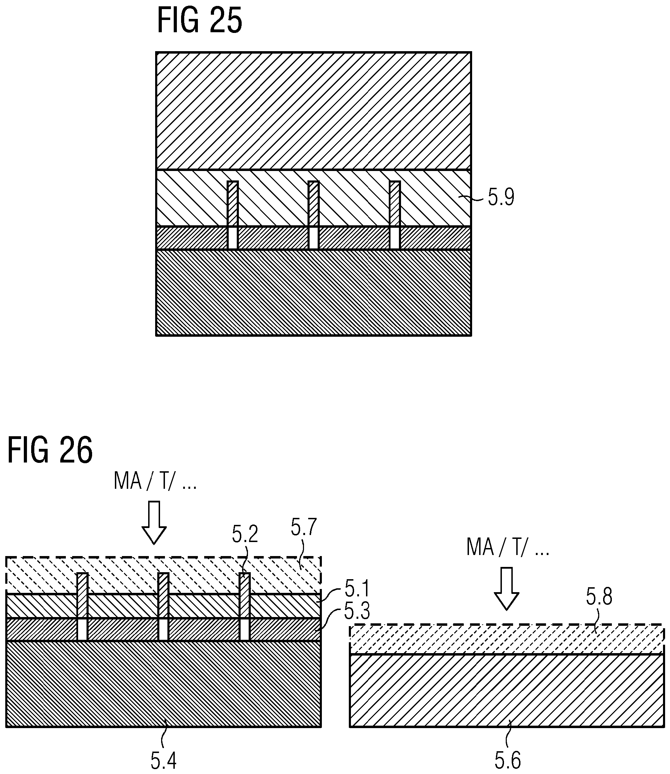

Ein entsprechendes Verfahren ist in Figuren 23 bis 25 schematisch gezeigt. Auf dem Substrat 5.4 befindet sich, wie in Figur 23 gezeigt, die erste, pixelierte Elektrodenschicht 5.3, und darauf über den Zwischenräumen zwischen den Elektrodenpixeln die Struktur 5.2. Die erste Schicht 5.6 wird teilweise durch MA-Gas, Temperatur, etc. verflüssigt, sodass sich ein verflüssigter Teil 5.8 bildet. Wie in Figur 24 gezeigt wird dieser verflüssigte Teil 5.8 dann mit der Struktur 5.2 und der ersten, pixelierten Elektrodenschicht 5.3 kontaktiert bzw. auf dieser positioniert. Danach wird der verflüssigte Teil 5.8 erstarrt, und es bildet sich, wie in Figur 25 gezeigt, ein rekristallisierter Teil 5.9 der ersten Schicht 5.6.

Auch Mischformen und abgeleitete Versionen beider Verfahren sind möglich, wenn zusätzlich beispielweise eine zweite Schicht umfassend mindestens einen zweiten Perowskiten und/oder eine dritte Schicht umfassend mindestens einen Szintillator zusätzlich aufgebracht wird, sodass sich ein Detektor mit einer dicken Absorberschicht ergibt, deren Haftung auf der ersten, pixelierten Elektrodenschicht durch die erste Schicht verbessert wird.

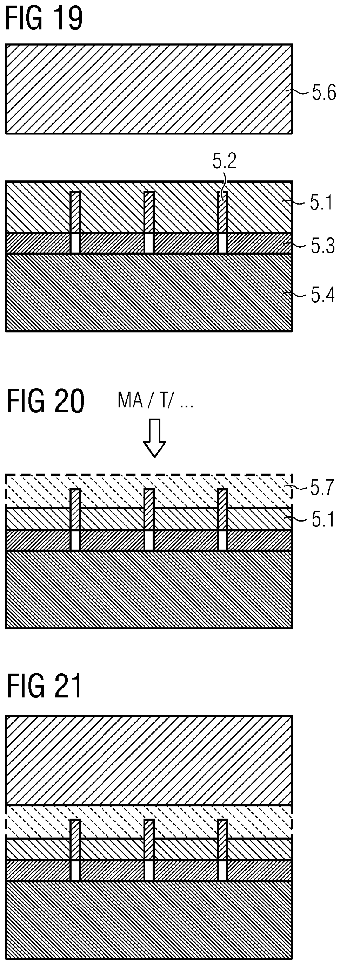

Eine beispielhafte abgeleitete Version ist in Figuren 19 bis 22 gezeigt. Hier wird, wie in Figur 19 gezeigt. eine zweite Schicht 5.6 umfassend mindestens einen zweiten Perowskiten, welcher vom mindestens einen ersten Perowskiten gleich oder verschieden sein kann, als dicke Absorberschicht, z.B. mit einer Dicke von 10-3000 µm, bevorzugt 50-2000 µm, mehr bevorzugt 100-1500 µm bereitgestellt, wobei diese in einem separaten Prozess hergestellt werden kann, z.B. durch Sintern, Walzen oder Hochtemperaturprozesse bereitgestellt, sodass hier eine Entkopplung von Prozessen zur Herstellung der Detektionsschicht möglich ist.

Zudem wird ein Substrat 5.4 mit erster, pixelierter Elektrodenschicht 5.3 und Struktur 5.2, hier beispielsweise als Gitterstruktur, bereitgestellt, wobei sich in der Struktur 5.2 und darüber die erste Schicht 5.1 befindet, welche hier beispielsweise einen flüssigen oder schon einen rekristallisierten ersten Perowskit aufweisen kann. Im in Figur 20 gezeigten Schritt wird ein Teil der ersten Schicht 5.1 durch MA-Gas und/oder (auch optional mit) Druck (z.B. 1-300MPa, bevorzugt 2-100MPa, mehr bevorzugt 3-50MPa je nach Material, insbesondere Perowskit) und/oder Temperatur (z.B. 0-600°C, je nach Material, insbesondere Perowskit), etc. erneut verflüssigt, sodass sich eine verflüssigte Schicht 5.7 bildet. Die angegebenen Drücke und Temperaturen lassen sich auch in den entsprechenden anderen Verfahren anwenden. Auf die verflüssigte Schicht 5.7 wird, wie in Figur 21 gezeigt, die zweite Schicht aufgebracht bzw. positioniert wobei sie gut an der verflüssigten Schicht 5.7 haftet. Nach Erstarren der verflüssigten Schicht 5.7 bildet sich wieder die erste Schicht 5.1 mit rekristallisiertem Perowskit, wie in Figur 22 gezeigt. Hierdurch wird die zweite Schicht 5.6 weiter fixiert.

Ein "Mischverfahren" ist in Figuren 26 bis 28 gezeigt, wobei dieses eine Art Mischung der Verfahren der Figuren 19 bis 22 und 23 bis 25 darstellt.

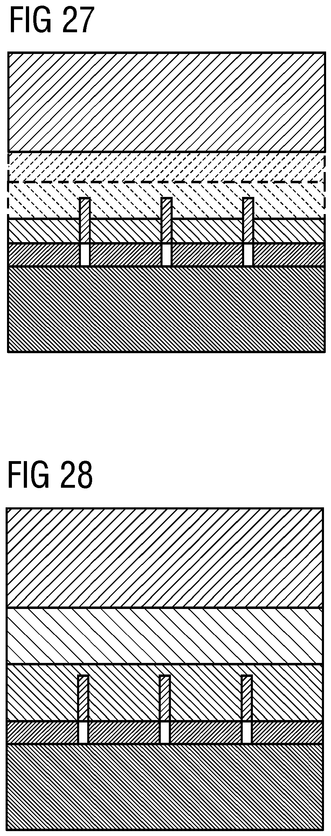

Wie in Figur 26 gezeigt wird wie in Figur 23 eine zweite Schicht 5.6 mit verflüssigtem Teil 5.8 bereitgestellt, wobei der verflüssigte Teil durch MA-Gas, Temperatur, etc. hergestellt werden kann, Zudem wird auf dem Substrat 5.4 mit erster, pixelierter Elektrodenschicht 5.3 und Struktur 5.2 eine erste Schicht 5.1 teilweise verflüssigt, um eine verflüssigte Schicht 5.7 bereitzustellen (entsprechend Figur 19), ebenfalls mittels MA-Gas, Temperatur, etc. Die verflüssigte Schicht 5.7 wird mit dem verflüssigten Teil 5.8 kontaktiert, wie in Figur 27 gezeigt. Nach dem Rekristallisieren bildet sich eine gemischte verbundene Struktur, wie in Figur 28 gezeigt. Es wird also sowohl ein Teil der zweiten Schicht, welche hier die hauptsächliche Absorberschicht darstellt, als auch ein Teil der ersten Schicht, die zur Haftvermittlung dient, verflüssigt, und beide in Kontakt gebracht, um die Schichten entsprechend auf der ersten, pixelierten Elektrodenschicht zu fixieren.

Auch weitere Mischformen und Varianten, die nicht in Zusammenhang mit den Figuren explizit beschrieben sind, jedoch zum selben Detektor führen, bei denen also ein erster Perowskit, insbesondere mindestens ein erster rekristallisierter Perowskit, in einer ersten Schicht mit der Struktur ganz oder teilweise in direkter Verbindung steht, also beispielsweise Verfahren mit anderen Füllgraden in der Struktur, etc., sind im erfindungsgemäßen Verfahren inbegriffen.

Im Anschluss an das Aufbringen der ersten und ggf. zweiten und/oder dritten Schicht wird die zweite Elektrode aufgebracht, wobei dies ebenfalls nicht besonders beschränkt ist. Es ist auch nicht ausgeschlossen, dass die zweite Elektrode zuvor auf einen nicht verflüssigten Teil der ersten Schicht, wie in der obigen Variante mit dem verflüssigten Teil angegeben, der zweiten oder der dritten Schicht aufgebracht wird.

Gemäß bestimmten Ausführungsformen umfasst das Einbringen der ersten Schicht umfassend mindestens einen ersten Perowskit ein zumindest teilweises Rekristallisieren des mindestens einen ersten Perowskits. Hierdurch wird die Haftung der ersten Schicht verbessert, wie oben dargelegt

Gemäß bestimmten Ausführungsformen wird zumindest die Struktur mit der ersten Schicht umfassend mindestens einen ersten Perowskit gefüllt. Hierdurch ist die Anbindung weiterer Schichten verbessert, wie oben dargelegt.

Gemäß bestimmten Ausführungsformen wird auf die erste Schicht umfassend mindestens einen ersten Perowskit eine zweite Schicht umfassend mindestens einen zweiten Perowskit und/oder eine dritte Schicht umfassend mindestens einen Szintillator aufgebracht. Die Materialien der Schichten entsprechen denen, die im Zusammenhang mit dem Detektor bereits genannt wurden.

Gemäß bestimmten Ausführungsformen wird die zweite Schicht umfassend mindestens einen zweiten Perowskit aufgebracht, wobei der mindestens eine zweite Perowskit zumindest teilweise nicht rekristallisiert wird. Es wird eine Entkopplung von der Herstellung der zweiten Schicht, die hauptsächlich als Absorberschicht dient (z.B. durch Sintern, Walzen oder Hochtemperatur-Prozesse etc.) und der Auftragung auf den weiteren Detektor (z.B. als Backplane ausgebildet), ermöglicht.

Gemäß bestimmten Ausführungsformen wird weiter eine elektronenleitende und/oder eine lochleitende Schicht zwischen der ersten, pixelierten Elektrodenschicht und der zweiten Elektrode eingebracht. Diese kann an geeigneter Stelle während des Verfahrens aufgebracht werden, also auf die erste, pixelierte Elektrodenschicht, die erste Schicht, die zweite und/oder dritte Schicht, etc., wie oben im Zusammenhang mit dem Detektor dargelegt. Die Materialien der Schichten entsprechen denen, die im Zusammenhang mit dem Detektor bereits genannt wurden.

Gemäß bestimmten Ausführungsformen wird die erste, pixelierte Elektrode auf ein Substrat aufgebracht. Dieses ist nicht besonders beschränkt und kann wie oben im Zusammenhang mit dem Detektor ausgestaltet sein.

Gemäß bestimmten Ausführungsformen weist das Substrat eine Vielzahl von Transistoren auf, wobei bevorzugt die erste, pixelierte Elektrodenschicht derart aufgebracht wird, dass mindestens jeweils ein Transistor ein Elektrodenpixel der ersten, pixelierten Elektrodenschicht kontaktiert.

Ebenfalls offenbart ist die Verwendung einer Struktur zur Erhöhung der Haftung zwischen einer pixelierten Elektrodenschicht umfassend eine Vielzahl von Elektrodenpixel und einer Schicht, insbesondere einer Detektionsschicht, umfassend mindestens einen ersten Perowskiten, wobei die pixelierte Elektrodenschicht und die Schicht umfassend mindestens einen ersten Perowskiten beide in Kontakt mit der Struktur sind, und insbesondere deren Verwendung in einem Detektor, insbesondere einem Röntgen- und/oder Gammadetektor.

Die obigen Ausführungsformen, Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmalen der Erfindung. Insbesondere wird der Fachmann auch Einzelaspekte als Verbesserungen oder Ergänzungen zu der jeweiligen Grundform der vorliegenden Erfindung hinzufügen.

Die Erfindung wird im Anschluss mit Bezug auf verschiedene Beispiele davon weiter im Detail erläutert. Die Erfindung ist jedoch nicht auf diese Beispiele beschränkt.

Auf eine erste Elektrodenschicht mit Elektrodenpixeln aus beispielsweise ITO oder Pt wird zwischen den Elektrodenpixeln entsprechend Figur 3 eine Struktur aus SU-8 als Photolack gebildet. In die Struktur wird entsprechend Figuren 12 bis 14 MAPI (CH₃NH₃PbI₃) als erster Perowskit in Pulverform eingebracht, mit MA-Gas verflüssigt und rekristallisiert. Entsprechend Figuren 19 bis 22 wird eine zweite Schicht aus MAPI, die als Absorberschicht mittels Sintern hergestellt wurde, wobei die erste Schicht erneut verflüssigt und nach dem Inkontaktbringen mit der zweiten Schicht rekristallisiert wird, aufgebracht, und darauf eine zweite Elektrode aus Cr oder Ti aufgebracht. Im Vergleich zu einem Aufbau ohne Struktur ergibt sich eine verbesserte Haftung.

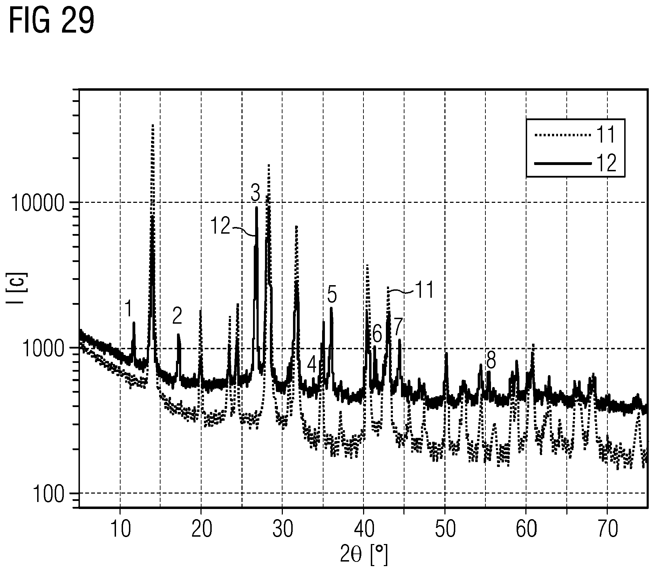

Wie aus den in Figur 29 gezeigten XRD-Spektren hervorgeht, in denen der Winkel 20 in ° gegen die Intensität I in Count c aufgetragen ist, weist das mit MA-Gas behandelte MAPI 12 der ersten Schicht im Vergleich zum unbehandelten MAPI 11 der zweiten Schicht acht weitere Peaks 1 bis 8 auf, woraus die Strukturänderung der Kristalle des MAPI in der ersten Schicht hervorgeht.

Da im Beispiel in der ersten Schicht dasselbe Material wie in der zweiten Schicht verwendet wurde, ergaben sich bei der Verwendung in einem Röntgendetektor keine Verluste im Auslesesignal und auch keine thermischen Spannungen durch die Prozessierung.

## Patentansprüche

1. Detektor für elektromagnetische Strahlung, insbesondere Röntgen- und/oder Gammadetektor, umfassend:
- eine erste, pixelierte Elektrodenschicht (3.3; 5.3) umfassend eine Vielzahl von Elektrodenpixeln (1.5) sowie Zwischenräume zwischen den einzelnen Elektrodenpixeln (1.5),
- eine zweite Elektrode (1.1), und
- eine erste Schicht (1.3; 3.6; 5.1) umfassend mindestens einen ersten Perowskit, welche sich zwischen der ersten, pixelierten Elektrodenschicht (3.3; 5.3) und der zweiten Elektrode (1.1) befindet,
**dadurch gekennzeichnet,**
**dass** der Detektor für elektromagnetische Strahlung weiter eine Struktur (1.4; 3.2; 5.2) umfasst, welche sich zumindest teilweise zwischen der ersten, pixelierten Elektrodenschicht (3.3; 5.3) und der zweiten Elektrode (1.1) befindet und zumindest teilweise zwischen einzelnen Elektrodenpixeln (1.5) der ersten, pixelierten Elektrodenschicht (3.3; 5.3) derart angeordnet ist, dass sie zumindest teilweise auf den Zwischenräumen zwischen den einzelnen Elektrodenpixeln (1.5) in Richtung der zweiten Elektrode (1.1) von der ersten Elektrodenschicht (3.3; 5.3) weg angeordnet ist, wobei die erste Schicht (1.3; 3.6; 5.1) umfassend mindestens einen ersten Perowskit zumindest teilweise in der Struktur (1.4; 3.2; 5.2) eingebracht ist.

2. Detektor für elektromagnetische Strahlung nach Patentanspruch 1, wobei der mindestens eine erste Perowskit in der ersten Schicht (1.3; 3.6; 5.1) umfassend mindestens einen ersten Perowskit zumindest teilweise rekristallisiert (5.9) ist.

3. Detektor für elektromagnetische Strahlung nach Patentanspruch 1 oder 2, wobei die erste Schicht (1.3; 3.6; 5.1) umfassend mindestens einen ersten Perowskit zumindest die Struktur (1.4; 3.2; 5.2) füllt.

4. Detektor für elektromagnetische Strahlung nach einem der vorgehenden Patentansprüche, weiter umfassend eine zweite Schicht (1.2; 5.6) umfassend mindestens einen zweiten Perowskit, welche sich zwischen der ersten Schicht (1.3; 3.6; 5.1) umfassend mindestens einen ersten Perowskit und der zweiten Elektrode (1.1) befindet,
und/oder weiter umfassend eine dritte Schicht umfassend mindestens einen Szintillator, welche sich zwischen der ersten Schicht (1.3; 3.6; 5.1) umfassend mindestens einen ersten Perowskit und der zweiten Elektrode (1.1) befindet.

5. Detektor für elektromagnetische Strahlung nach Patentanspruch 4, umfassend die zweite Schicht (1.2; 5.6) umfassend den mindestens einen zweiten Perowskit, wobei der mindestens eine zweite Perowskit zumindest teilweise nicht rekristallisiert ist.

6. Detektor für elektromagnetische Strahlung nach einem der vorgehenden Patentansprüche, weiter umfassend eine elektronenleitende und/oder eine lochleitende Schicht, welche sich zwischen der ersten, pixelierten Elektrodenschicht (3.3; 5.3) und der zweiten Elektrode (1.1) befindet.

7. Detektor für elektromagnetische Strahlung nach einem der vorgehenden Patentansprüche, weiter umfassend ein Substrat (1.6; 3.4; 5.4), auf welchem sich die erste, pixelierte Elektrodenschicht (3.3; 5.3) befindet, wobei das Substrat (1.6; 3.4; 5.4) bevorzugt eine Vielzahl von Transistoren (1.7) aufweist, wobei weiter bevorzugt jeweils mindestens ein Transistor (1.7) ein Elektrodenpixel (1.5) der ersten, pixelierten Elektrodenschicht (3.3; 5.3) kontaktiert.

8. Verfahren zur Herstellung eines Detektors für elektromagnetische Strahlung, insbesondere eines Röntgen- und/oder Gammadetektors, umfassend:
- Bereitstellen einer ersten, pixelierten Elektrodenschicht (3.3; 5.3) umfassend eine Vielzahl von Elektrodenpixeln (1.5) sowie Zwischenräume zwischen den einzelnen Elektrodenpixeln (1.5);
- Aufbringen einer Struktur (1.4; 3.2; 5.2) zumindest teilweise auf die Zwischenräume der ersten, pixelierten Elektrodenschicht (3.3; 5.3), wobei die Struktur (1.4; 3.2; 5.2) derart aufgebracht wird, dass die Struktur (1.4; 3.2; 5.2) zumindest teilweise auf den Zwischenräumen zwischen den einzelnen Elektrodenpixeln (1.5) von der ersten Elektrodenschicht (3.3; 5.3) weg angeordnet ist;
- Einbringen einer ersten Schicht (1.3; 3.6; 5.1) umfassend mindestens einen ersten Perowskit in die Struktur (1.4; 3.2; 5.2); und
- Aufbringen einer zweiten Elektrode (1.1) auf die Struktur (1.4; 3.2; 5.2) und/oder die erste Schicht (1.3; 3.6; 5.1) umfassend mindestens einen ersten Perowskit; oder
- Bereitstellen einer Struktur (1.4; 3.2; 5.2), wobei die Struktur (1.4; 3.2; 5.2) Zwischenräume aufweist;
- Einbringen einer Vielzahl von Elektrodenpixel (1.5) zwischen die Zwischenräume der Struktur (1.4; 3.2; 5.2), wobei die Elektrodenpixel die Struktur (1.4; 3.2; 5.2) nicht füllen, und dadurch bilden einer ersten, pixelierten Elektrodenschicht (3.3; 5.3);
- Einbringen einer ersten Schicht (1.3; 3.6; 5.1) umfassend mindestens einen ersten Perowskit in die Struktur (1.4; 3.2; 5.2); und
- Aufbringen einer zweiten Elektrode (1.1) auf die Struktur (1.4; 3.2; 5.2) und/oder die erste Schicht (1.3; 3.6; 5.1) umfassend mindestens einen ersten Perowskit.

9. Verfahren nach Patentanspruch 8, wobei das Einbringen der ersten Schicht (1.3; 3.6; 5.1) umfassend mindestens einen ersten Perowskit ein zumindest teilweises Rekristallisieren des mindestens einen ersten Perowskits umfasst.

10. Verfahren nach Patentanspruch 8 oder 9, wobei zumindest die Struktur (1.4; 3.2; 5.2) mit der ersten Schicht (1.3; 3.6; 5.1) umfassend mindestens einen ersten Perowskit gefüllt wird.

11. Verfahren nach einem der Patentansprüche 8 bis 10, wobei auf die erste Schicht (1.3; 3.6; 5.1) umfassend mindestens einen ersten Perowskit eine zweite Schicht (1.2; 5.6) umfassend mindestens einen zweiten Perowskit und/oder eine dritte Schicht umfassend mindestens einen Szintillator aufgebracht wird.

12. Verfahren nach Patentanspruch 11, wobei die zweite Schicht (1.2; 5.6) umfassend mindestens einen zweiten Perowskit aufgebracht wird, wobei der mindestens eine zweite Perowskit zumindest teilweise nicht rekristallisiert wird.

13. Verfahren nach einem der Patentansprüche 8 bis 12, wobei weiter eine elektronenleitende und/oder eine lochleitende Schicht zwischen der ersten, pixelierten Elektrodenschicht (3.3; 5.3) und der zweiten Elektrode (1.1) eingebracht wird.

14. Verfahren nach einem der Patentansprüche 8 bis 13, wobei die erste, pixelierte Elektrodenschicht (3.3; 5.3) auf ein Substrat (1.6; 3.4; 5.4) aufgebracht wird.

15. Verfahren nach Patentanspruch 14, wobei das Substrat (1.6; 3.4; 5.4) eine Vielzahl von Transistoren (1.7) aufweist, wobei bevorzugt die erste, pixelierte Elektrodenschicht derart aufgebracht wird, dass mindestens jeweils ein Transistor (1.7) ein Elektrodenpixel (1.5) der ersten, pixelierten Elektrodenschicht (3.3; 5.3) kontaktiert.

## Claims

1. Detector for electromagnetic radiation, in particular an X-ray and/or gamma detector, comprising:
- a first, pixelated electrode layer (3.3; 5.3) comprising a plurality of electrode pixels (1.5) as well as intermediate spaces between the individual electrode pixels (1.5),
- a second electrode (1.1), and
- a first layer (1.3; 3.6; 5.1) comprising at least one first perovskite, which is located between the first, pixelated electrode layer (3.3; 5.3) and the second electrode (1.1),
**characterised in that**
the detector for electromagnetic radiation further comprises a structure (1.4; 3.2; 5.2), which is located at least partly between the first, pixelated electrode layer (3.3; 5.3) and the second electrode (1.1) and is arranged at least partly between individual electrode pixels (1.5) of the first, pixelated electrode layer (3.3; 5.3) in such a way that it is arranged at least partly on the intermediate spaces between the individual electrode pixels (1.5) in the direction of the second electrode (1.1) away from the first electrode layer (3.3; 5.3), wherein the first layer (1.3; 3.6; 5.1) comprising at least one first perovskite is at least partly introduced into the structure (1.4; 3.2; 5.2).

2. Detector for electromagnetic radiation according to claim 1, wherein the at least one first perovskite in the first layer (1.3; 3.6; 5.1) comprising at least one first perovskite is at least partly recrystallised (5.9).

3. Detector for electromagnetic radiation according to claim 1 or 2, wherein the first layer (1.3; 3.6; 5.1) comprising at least one first perovskite at least fills the structure (1.4; 3.2; 5.2).

4. Detector for electromagnetic radiation according to one of the preceding claims, further comprising a second layer (1.2; 5.6) comprising at least one second perovskite, which is located between the first layer (1.3; 3.6; 5.1) comprising at least one first perovskite and the second electrode (1.1), and/or further comprising a third layer comprising at least one scintillator, which is located between the first layer (1.3; 3.6; 5.1) comprising at least one first perovskite and the second electrode (1.1).

5. Detector for electromagnetic radiation according to claim 4, comprising the second layer (1.2; 5.6) comprising the at least one second perovskite, wherein the at least one second perovskite is at least partly not recrystallised.

6. Detector for electromagnetic radiation according to one of the preceding claims, further comprising an electron-conducting and/or a hole-conducting layer, which is located between the first, pixelated electrode layer (3.3; 5.3) and the second electrode (1.1).

7. Detector for electromagnetic radiation according to one of the preceding claims, further comprising a substrate (1.6; 3.4; 5.4), on which the first, pixelated electrode layer (3.3; 5.3) is located, wherein the substrate (1.6; 3.4; 5.4) preferably has a plurality of transistors (1.7), wherein further preferably at least one transistor (1.7) in each case makes contact with an electrode pixel (1.5) of the first, pixelated electrode layer (3.3; 5.3).

8. Method for manufacturing a detector for electromagnetic radiation, in particular an X-ray and/or gamma detector, comprising:
- provision of a first, pixelated electrode layer (3.3; 5.3) comprising a plurality of electrode pixels (1.5) as well as intermediate spaces between the individual electrode pixels (1.5);
- application of a structure (1.4; 3.2; 5.2) at least partly to the intermediate spaces of the first, pixelated electrode layer (3.3; 5.3), wherein the structure (1.4; 3.2; 5.2) is applied in such a way that the structure (1.4; 3.2; 5.2) is arranged at least partly on the intermediate spaces between the individual electrode pixels (1.5) away from the first electrode layer (3.3; 5.3);
- introduction of a first layer (1.3; 3.6; 5.1) comprising at least one first perovskite into the structure (1.4; 3.2; 5.2); and
- application of a second electrode (1.1) to the structure (1.4; 3.2; 5.2) and/or the first layer (1.3; 3.6; 5.1) comprising at least one first perovskite; or
- provision of a structure (1.4; 3.2; 5.2), wherein the structure (1.4; 3.2; 5.2) has intermediate spaces;
- introduction of a plurality of electrode pixels (1.5) between the intermediate spaces of the structure (1.4; 3.2; 5.2), wherein the electrode pixels do not fill the structure (1.4; 3.2; 5.2), and thereby formation of a first, pixelated electrode layer (3.3; 5.3);
- introduction of a first layer (1.3; 3.6; 5.1) comprising at least one first perovskite in the structure (1.4; 3.2; 5.2); and
- application of a second electrode (1.1) to the structure (1.4; 3.2; 5.2) and/or the first layer (1.3; 3.6; 5.1) comprising at least one first perovskite.

9. Method according to claim 8, wherein the introduction of the first layer (1.3; 3.6; 5.1) comprising at least one first perovskite comprises an at least part recrystallisation of the at least one first perovskite.

10. Method according to claim 8 or 9, wherein at least the structure (1.4; 3.2; 5.2) is filled with the first layer (1.3; 3.6; 5.1) comprising at least one first perovskite.

11. Method according to one of claims 8 to 10, wherein a second layer (1.2; 5.6) comprising at least one second perovskite and/or a third layer comprising at least one scintillator is applied to the first layer (1.3; 3.6; 5.1) comprising at least one first perovskite.

12. Method according to claim 11, wherein the second layer (1.2; 5.6) comprising at least one second perovskite is applied, wherein the at least one second perovskite is at least partly not recrystallised.

13. Method according to one of claims 8 to 12, wherein an electron-conducting and/or a hole-conducting layer is further introduced between the first, pixelated electrode layer (3.3; 5.3) and the second electrode (1.1).

14. Method according to one of claims 8 to 13, wherein the first, pixelated electrode layer (3.3; 5.3) is applied to a substrate (1.6; 3.4; 5.4).

15. Method according to claim 14, wherein the substrate (1.6; 3.4; 5.4) has a plurality of transistors (1.7), wherein preferably the first, pixelated electrode layer is introduced in such a way that at least one transistor (1.7) in each case makes contact with an electrode pixel (1.5) of the first, pixelated electrode layer (3.3; 5.3).

## Revendications

1. Détecteur du rayonnement électromagnétique, en particulier détecteur de rayons X et/ou gamma, comprenant :
- une première couche (3.3 ; 5.3) d'électrode pixèlée, comprenant une pluralité de pixels (1.5) d'électrode ainsi que des espaces intermédiaires entre les divers pixels (1.5) d'électrode,
- une deuxième électrode (1.1), et
- une première couche (1.3 ; 3.6 ; 5.1) comprenant au moins une première perovskite, qui se trouve entre la première couche (3.3 ; 5.3) d'électrode pixèlée et la deuxième électrode (1.1),
**caractérisé**
**en ce que** le détecteur du rayonnement électromagnétique comprend en outre une structure (1.4 ; 3.2 ; 5.2), qui se trouve au moins en partie entre la première couche (3.3 ; 5.3) d'électrode pixèlée et la deuxième électrode (1.1), et est disposée au moins en partie entre des pixels (1.5) d'électrode individuels de la première couche (3.3 ; 5.3) d'électrode pixèlée, de manière à être éloignée de la première couche (3.3 ; 5.3) d'électrode dans la direction de la deuxième électrode (1.1) au moins en partie sur les espaces intermédiaires entre les divers pixels (1.5) d'électrode, dans lequel la première couche (1.3 ; 3.6 ; 5.1) comprenant au moins une première perovskite, est incorporée au moins en partie dans la structure (1.4 ; 3.2 ; 5.2).

2. Détecteur du rayonnement électromagnétique suivant la revendication 1, dans lequel la au moins une première perovskite dans la première couche (1.3 ; 3.6 ; 5.1) comprenant au moins une première perovskite est recristallisée (5.9) au moins en partie.

3. Détecteur du rayonnement électromagnétique suivant la revendication 1 ou 2, dans lequel la première couche (1.3 ; 3.6 ; 5.1) comprenant au moins une première perovskite remplit au moins la structure (1.4 ; 3.2 ; 5.2).

4. Détecteur du rayonnement électromagnétique suivant l'une des revendications précédentes, comprenant en outre une deuxième couche (1.2 ; 5.6) comprenant au moins une deuxième perovskite, qui se trouve entre la première couche (1.3 ; 3.6 ; 5.1) comprenant au moins une première perovskite et la deuxième électrode (1.1),
et/ou comprenant en outre une troisième couche comprenant au moins un scintillateur, qui se trouve entre la première couche (1.3 ; 3.6 ; 5.1) comprenant au moins une première perovskite et la deuxième électrode (1.1).

5. Détecteur du rayonnement électromagnétique suivant la revendication 4, comprenant la deuxième couche (1.2 ; 5.6) comprenant la au moins une deuxième perovskite, la au moins une deuxième perovskite n'étant pas recristallisée au moins en partie.

6. Détecteur du rayonnement électromagnétique suivant l'une des revendications précédentes, comprenant en outre une couche conductrice d'électrons et/ou conductrice de trous, qui se trouve entre la première couche (3.3 ; 5.3) d'électrode pixèlée et la deuxième électrode (1.1).

7. Détecteur du rayonnement électromagnétique suivant l'une des revendications précédentes, comprenant en outre un substrat (1.6 ; 3.4 ; 5.4), sur lequel se trouve la première couche (3.3 ; 5.3) d'électrode pixèlée, dans lequel le substrat (1.6 ; 3.4 ; 5.4) a de préférence une pluralité de transistors (1.7), dans lequel en outre, de préférence, respectivement au moins un transistor (1.7) est en contact avec un pixel (1.5) d'électrode de la première couche (3.3 ; 5.3) d'électrode pixèlée.

8. Procédé de fabrication d'un détecteur du rayonnement électromagnétique, en particulier détecteur de rayons X et/ou gamma, comprenant :
- on se procure une première couche (3.3 ; 5.3) d'électrode pixèlée comprenant une pluralité de pixels (1.5) d'électrode ainsi que des espaces intermédiaires entre les divers pixels (1.5) d'électrode ;
- on dépose une structure (1.4 ; 3.2 ; 5.2) au moins en partie sur les espaces intermédiaires de la première couche (3.3 ; 5.3) d'électrode pixèlée, dans lequel on dépose la structure (1.4 ; 3.2 ; 5.2), de manière à ce que la structure (1.4 ; 3.2 ; 5.2) soit éloignée de la première couche (3.3 ; 5.3) d'électrode au moins en partie sur les espaces intermédiaires entre les divers pixels (1.5) d'électrode ;
- on incorpore une première couche (1.3 ; 3.6 ; 5.1) comprenant au moins une première perovskite dans la structure (1.4 ; 3.2 ; 5.2) ; et
- on dépose une deuxième électrode (1.1) sur la structure (1.4 ; 3.2 ; 5.2) et/ou sur la première couche (1.3 ; 3.6 ; 5.1) comprenant au moins une première perovskite ; ou
- on se procure une structure (1.4 ; 3.2 ; 5.2), la structure (1.4 ; 3.2 ; 5.2) ayant des espaces intermédiaires ;
- on introduit une pluralité de pixels (1.5) d'électrode entre les espaces intermédiaires de la structure (1.4 ; 3.2 ; 5.2), les pixels d'électrode ne remplissant pas la structure (1.4 ; 3.2 ; 5.2) et formant ainsi une première couche (3.3 ; 5.3) d'électrode pixèlée ;
- on introduit une première couche (1.3 ; 3.6 ; 5.1), comprenant au moins une première perovskite dans la structure (1.4 ; 3.2 ; 5.2) ; et
- on dépose une deuxième électrode (1.1) sur la structure (1.4 ; 3.2 ; 5.2) et/ou sur la première couche (1.3 ; 3.6 ; 5.1) comprenant au moins une première perovskite.

9. Procédé suivant la revendication 8, dans lequel l'introduction de la première couche (1.3 ; 3.6 ; 5.1) comprenant au moins une première perovskite, comprend une recristallisation au moins en partie de la au moins une première perovskite.

10. Procédé suivant la revendication 8 ou 9, dans lequel on remplit au moins la structure (1.4 ; 3.2 ; 5.2) de la première couche (1.3 ; 3.6 ; 5.1) comprenant au moins une première perovskite.

11. Procédé suivant l'une des revendications précédentes 8 à 10, dans lequel on dépose sur la première couche (1.3 ; 3.6 ; 5.1) comprenant au moins une première perovskite, une deuxième couche (1.2 ; 5.6) comprenant au moins une deuxième perovskite et/ou une troisième couche comprenant au moins un scintillateur.

12. Procédé suivant la revendication 11, dans lequel on dépose la deuxième couche (1.2 ; 5.6) comprenant au moins une deuxième perovskite, la au moins une deuxième perovskite, dans lequel on ne recristallise pas au moins en partie la au moins une deuxième perovskite.

13. Procédé suivant l'une des revendications précédentes 8 à 12, dans lequel on introduit en outre une couche conductrice d'électrons et/ou conductrice de trous entre la première couche (3.3 ; 5.3) d'électrode pixèlée et la deuxième électrode (1.1).

14. Procédé suivant l'une des revendications 8 à 13, dans lequel on dépose la première couche (3.3 ; 5.3) d'électrode pixèlée sur un substrat (1.6 ; 3.4 ; 5.4).

15. Procédé suivant la revendication 14, dans lequel le substrat (1.6 ; 3.4 ; 5.4) a une pluralité de transistors (1.7), dans lequel on dépose de préférence la première couche d'électrode pixèlée, de manière à ce qu'au moins respectivement un transistor (1.7) soit en contact avec un pixel (1.5) d'électrode de la première couche (3.3 ; 5.3) d'électrode pixèlée.
